# EUROPÄISCHE PATENTSCHRIFT

(11) **EP 2 058 841 B1**
(45) Veröffentlichungstag und Bekanntmachung des Hinweises auf die Patenterteilung: **21.05.2014**
(21) Anmeldenummer: 08167941.7
(22) Anmeldetag: 30.10.2008
(51) Int. Cl.: H01L 21/67, H01L 21/324

(54) **Wärmetransferelement und Anlage zur thermischen Behandlung von Substraten**
Heat transfer element and device for thermal treatment of substrates
Elément de transfert de chaleur et dispositif pour le traitement thermique de substrats

(30) Priorität: 07.11.2007 DE 102007054526
(43) Veröffentlichungstag der Anmeldung: 13.05.2009
(73) Patentinhaber: Deutsches Zentrum für Luft- und Raumfahrt e.V., 51147 Köln (DE)
(72) Erfinder: Dr. Hald, Hermann, 71287, Weissach (DE); Dr. Funk, Klaus, 85521, Ottobrunn (DE); Heidenreich, Bernhard, 71679, Asperg (DE)
(74) Vertreter: Hoeger, Stellrecht & Partner Patentanwälte

(56) Entgegenhaltungen:
- WO-A1-2007/105798
- WO-A2-02/061808
- DE-A1- 3 922 539

## Beschreibung

Die Erfindung betrifft ein flächenhaft ausgebildetes aufheizbares Wärmetransferelement für eine Anlage zur thermischen Behandlung von Substraten, insbesondere Halbleitersubstraten, sowie eine derartige Anlage zur thermischen Behandlung von Substraten, insbesondere Halbleitersubstraten.

Die DE 39 22 539 A1 offenbart ein Verfahren zur hochpräzisen Herstellung von Heizelementen aus CFC.

Die WO 2007/105798 A1 offenbart eine Vorrichtung zum Aufheizen von Substraten, bei welcher eine Abschirmplatte zwischen Heizung und Substrat in eine Abschirmposition einschiebbar ist, um das Substrat abzuschirmen, und aus dieser Abschirmposition herausbewegbar ist, um das Substrat aufzuheizen.

Die WO 02/061808 A2 offenbart eine Vorrichtung zum Aufheizen von Wafern mit einer Quarzplatte, die jedoch kein Wärmetransferelement darstellt.

Die bekannte thermische Behandlung von Substraten erfolgt insbesondere zu dem Zweck, in den Substraten jegliche Arten von Prozessen durchzuführen, insbesondere bei Halbleitersubstraten dazu, in den Halbleitersubstraten, beispielsweise Halbleiterwafern, thermisch aktivierbare Prozesse stattfinden zu lassen.

Derartige Anlagen zur thermischen Behandlung von Substraten, sind beispielsweise Anlagen zur schnellen thermischen Behandlung von Substraten, bei welchen die Wärmebehandlung mit Temperaturänderungen von mehr als 50K/sek, vorzugsweise Temperaturänderungen im Bereich von 100K/sek bis hin zu 1000K/sek realisiert werden, wobei Maximaltemperaturen von ungefähr 300°C bis ungefähr 1300°C für eine Zeitdauer im Bereich von ungefähr 1 bis ungefähr 10 sek erreicht werden.

Derartige schnelle Wärmebehandlungen finden beispielsweise Anwendung bei der Herstellung von Halbleiterbauelementen und dienen beispielsweise zur Durchführung folgender Prozesse: elektrische Aktivierung von Dotierelementen, Defekt-Ausheilung, Diffusion von chemischen Elementen, Oxidation von chemischen Elementen, Nitridierung, Silizidierung, Erzeugung von High-K Anneals, Durchführung von Epitaxie, Durchführung von Chemical Vapor Deposition, Materialverdichtung, Trocknungsvorgänge zur thermischen Entoxidierung im Vakuum sowie thermochemische Oxidierung.

Bei derartigen Anlagen zur thermischen Behandlung von Substraten, insbesondere Halbleitersubstraten ist ein Substrataufnahmeraum vorgesehen und auf mindestens einer Seite des Substrataufnahmeraum ein flächenhaft ausgebildetes aufheizbares Wärmetransferelement, mit welchem das Substrat im Substrataufnahmeraum berührungslos thermisch behandelbar ist.

Bei derartigen Wärmetransferelementen zur thermischen Behandlung von Substraten ist es - um schnelle thermische Behandlungsprozesse ausführen zu können - erforderlich, dass diese einerseits in der Lage sind, den erforderlichen Temperaturen stand zu halten, die erforderlichen Temperaturänderungsgeschwindigkeiten auszuführen und dies auch noch bei ausreichend guter mechanischer Langzeitstabilität.

Bei den bekannten Anlagen zur thermischen Behandlung von Substraten werden üblicherweise - zumindest bei der thermischen Behandlung von Halbleiterwafern - als Wärmetransferelemente ebenfalls Halbleiterwafer - vorzugsweise aus Silizium - eingesetzt, deren mechanische Stabilität im eingangs genannten Temperaturbereich grenzwertig ist und die außerdem bereits aufgrund ihrer Wärmespeicherkapazität die Temperaturänderungsgeschwindigkeiten begrenzen.

Der Erfindung liegt daher die Aufgabe zugrunde, ein Wärmetransferelement der eingangs beschriebenen Art zu schaffen, das bei guter mechanischer Langzeitstabilität hohe Temperaturänderungsgeschwindigkeiten zulässt.

Diese Aufgabe wird bei einem Wärmetransferelement der eingangs beschriebenen Art erfindungsgemäß dadurch gelöst, dass das flächenhaft ausgebildete Wärmetransferelement ein Membranelement mit mindestens einer Membran umfasst, dass die Membran durch mindestens eine Matte aus hochtemperaturbeständigen und thermoschockresistenten Fasern gebildet ist und dass die Fasern im Wesentlichen parallel zu einer Fläche verlaufen, in welcher sich die Matte erstreckt.

Der Vorteil der erfindungsgemäßen Lösung ist darin zu sehen, dass mit einer Matte aus derartigen Fasern eine Membran gebildet werden kann, die einerseits eine geringe Wärmespeicherkapazität und somit eine geringe thermische Masse aufweist und andererseits aufgrund der hochtemperaturbeständigen und thermoschockresistenten Fasern in der Lage ist, eine gute mechanische Langzeitstabilität zu gewährleisten, so dass das Wärmetransferelement einer Vielzahl von Temperaturwechseln mit hoher Temperaturänderungsgeschwindigkeit Stand halten kann.

Somit lassen sich mit dem erfindungsgemäßen Wärmetransferelement schnelle thermische Behandlungsprozesse noch präziser und somit reproduzierbarer ausführen.

Im Zusammenhang mit der Erläuterung des erfindungsgemäßen Gedankens wurden die hochtemperaturbeständigen Fasern nicht näher spezifiziert. Unter hochtemperaturbeständigen Fasern im Sinne der erfindungsgemäßen Lösung sind dabei vorzugsweise Fasern zu verstehen, die einer Temperatur von mehr als 500°C, noch besser mehr als 700°C, Stand halten.

Besonders zweckmäßig ist es im Rahmen der erfindungsgemäßen Lösung, wenn die hochtemperaturbeständigen Fasern mindestens einer Temperatur von bis zu 1000°C, noch besser bis zu 1200°C, Stand halten.

Die erfindungsgemäßen hochtemperaturbeständigen und thermoschockresistenten Fasern wurden hinsichtlich des Materials, aus dem sie hergestellt sind, nicht näher spezifiziert.

So sieht eine vorteilhafte Lösung vor, dass die Fasern C-Fasern umfassen, das heißt Kohlenstofffasern umfassen, die diese Anforderungen erfüllen.

Eine weitere vorteilhafte Variante sieht vor, dass die erfindungsgemäßen hochtemperaturbeständigen thermoschockresistenten Fasern Keramikfasern umfassen. Hierbei kommen insbesondere oxidische und/oder nichtoxidische Keramikfasern in Frage.

Bei einer vorteilhaften Ausführungsform ist dabei vorgesehen, dass die Fasern Siliziumcarbid-Fasern oder Aluminiumoxidfasern umfassen.

Hinsichtlich der Ausbildung der Matte im Rahmen der erfindungsgemäßen Lösung wurden bislang keine näheren Angaben gemacht.

So wäre es beispielsweise denkbar, dass die Matte ein Flies aus Fasern umfasst.

Eine andere vorteilhafte Ausführungsform sieht beispielsweise vor, dass die Matte ein Gewirke aus Fasern umfasst.

Eine weitere vorteilhafte Lösung sieht vor, dass die Matte ein Gestrick aus Fasern umfasst.

Als besonders vorteilhaft hat es sich herausgestellt, wenn die Matte ein Gewebe aus den Fasern umfasst, da bei einem Gewebe in einfacher Weise ein mechanischer Verbund herstellbar ist, in dem die Fasern relativ zueinander definiert angeordnet sind, ohne dass es erforderlich ist, die Fasern zwingend noch zusätzlich miteinander zu verbinden.

Hinsichtlich der Dicke einer derartigen Matte wurden ebenfalls keine näheren Angaben gemacht. So ist es vorteilhaft, wenn die Matte eine Dicke von maximal 0,5 mm aufweist.

Andererseits ist es vorteilhaft, wenn die Matte eine Dicke von mindestens 0,07 mm aufweist.

Üblicherweise ist insbesondere im Falle eines Gewebes vorgesehen, dass die Matte eine Faserlage umfasst, wobei unter einer Faserlage zu verstehen ist, dass die Fasern in unterschiedlichster Richtung verlaufen und somit die in unterschiedlichen Richtungen verlaufenden Fasern in Kreuzungsbereichen übereinander liegen können, während in dieselben Richtungen verlaufende Fasern mindestens in der Regel nicht übereinander liegen.

Um die Membran stabiler ausführen zu können, ist vorgesehen, dass die Membran nicht nur aus einer Matte gebildet ist, sondern auch aus mehreren Matten gebildet sein kann.

Hinsichtlich der Ausbildung der Matten besteht grundsätzlich die Möglichkeit, die Fasern ohne eine zusätzliche Verbindung zueinander, beispielsweise in Form eines Gewebes in der Matte, zu fixieren und somit der Matte insgesamt einen ausreichenden mechanischen Zusammenhang zu geben.

Noch vorteilhafter ist es jedoch, wenn die Matte als Faserverbundwerkstoff ausgebildet ist, das heißt einerseits Fasern und andererseits ein Material aufweist, das einen Verbund der Fasern herstellt.

Dieser Verbund der Fasern könnte beispielsweise durch eine Beschichtung der Fasern realisiert sein.

Besonders vorteilhaft ist es, wenn die Fasern durch ein Matrixmaterial miteinander verbunden sind.

Das kann in unterschiedlichster Art und Weise ausgebildet sein. Eine vorteilhafte Lösung sieht vor, dass das Matrixmaterial Kohlenstoff und/oder Keramik umfasst.

Um die Eigenschaften der Membran in einfacher Weise variieren zu können, ist vorzugsweise vorgesehen, dass die Membran eine Beschichtung trägt.

Beispielsweise ist vorgesehen, dass die Membran auf ihrer dem Substrat zugewandten Vorderseite eine Beschichtung trägt, mit welcher beispielsweise die Möglichkeit besteht, das Wärmeaustauschverhalten zwischen der Membran und dem Substrat zu beeinflussen, beispielsweise im Falle einer Abstrahlung von Wärme das Abstrahlverhalten der Membran in Richtung des Substrats zu beeinflussen und den gewünschten Bedingungen anzupassen.

Andererseits sieht eine weitere vorteilhafte Lösung vor, dass die Membran auf ihrer dem Substrat abgewandten Rückseite eine Beschichtung trägt, die es beispielsweise erlaubt, ebenfalls die Eigenschaften der Membran, beispielsweise die für die Aufheizung der Membran notwendigen Eigenschaften zu beeinflussen. Die Beschichtung auf der Rückseite der Membran kann beispielsweise dahingehend angepasst werden, dass die Membran bei Absorption von Strahlung diese Strahlung einer Aufheizeinrichtung optimal absorbiert.

Eine weitere Lösung sieht vor, die Membran durch eine Beschichtung gasdicht auszuführen.

Hinsichtlich der Beschichtung sind die unterschiedlichsten Möglichkeiten denkbar.

Eine Möglichkeit sieht vor, dass die Beschichtung eine durch Plasmaspritzen hergestellte Beschichtung ist.

Eine andere Möglichkeit sieht vor, dass die Beschichtung eine durch PVD, das heißt Physical Vapor Deposition, oder eine durch CVD, das heißt Chemical Vapor Deposition, oder eine durch CVI, das heißt Chemical Vapor Infiltration, hergestellte Beschichtung ist.

Die Beschichtung kann dabei in unterschiedlichster Dicke ausgebildet sein.

Eine vorteilhafte Lösung sieht vor, dass die Beschichtung eine Dicke von mindestens 10 nm (100 Å) aufweist.

Ferner sieht eine weitere vorteilhafte Lösung vor, dass die Beschichtung eine Dicke von maximal 300 nm (3000 Å) aufweist.

Hinsichtlich der Ausbildung der Membran selbst wurden bislang keine näheren Angaben gemacht.

So ist es beispielsweise möglich, die Membran selbst gasdicht auszubilden.

Eine andere vorteilhafte Möglichkeit sieht vor, dass die Membran Durchlassöffnungen aufweist, wozu die Membran beispielsweise porös ausgebildet ist.

Eine poröse Ausbildung der Membran eröffnet die Möglichkeit, die Membran von einem Medium, beispielsweise einem Prozessgas oder einem Kühlgas, durchströmen zu lassen.

Insbesondere bei der Möglichkeit, die Membran von einem Kühlgas durchströmen zu lassen, ist die Kühlung der Membran noch effizienter durchführbar.

Hinsichtlich der Porosität der Membran wurden dabei keine näheren Angaben gemacht. So sieht eine vorteilhafte Lösung vor, dass die Membran eine Porosität von mindestens 3 % aufweist. Ferner ist von Vorteil, wenn die Membran eine Porosität von maximal 50 % aufweist.

Grundsätzlich kann die Porengröße oder die Strömungsdurchlässigkeit der Membran über die ganze Membran gleich groß sein.

Dies hat jedoch zur Folge, dass die diffuse Gasströmung zwischen der Membran und dem Substrat dann, wenn diese zwischen Membran und Substrat in radialer Richtung abströmen soll, unterschiedliche Gasgeschwindigkeiten über dem Substrat hat, da der Gasstrom, der im Zentralbereich auf das Substrat trifft, über das Substrat hinwegströmt und sich dann die Gasströme aus den radial weiter außen liegenden Bereichen um den Zentralbereich herum zu den jeweils innen liegenden Gasströmen addieren.

Aus diesem Grund ist vorzugsweise vorgesehen, dass ein Strömungsquerschnitt der Durchlassöffnungen in einem Zentralbereich der Membran gegenüber einem Außenbereich der Membran unterschiedlich ist.

Als besonders vorteilhaft hat es sich erwiesen, wenn der Strömungsquerschnitt der Durchlassöffnungen in dem Zentralbereich größer ist als in dem Außenbereich.

Dabei ist vorzugsweise der Strömungsquerschnitt der Durchlassöffnungen in dem Zentralbereich um mindestens einen Faktor 2 größer als im Außenbereich.

Noch besser ist es, wenn der Strömungsquerschnitt der Durchlassöffnungen in dem Zentralbereich um ungefähr einen Faktor 3 größer ist als in dem Außenbereich.

Dabei könnte der Durchlassquerschnitt sich von dem Zentralbereich zum Außenbereich hin entweder in einer oder mehreren Stufen ändern.

Besonders zweckmäßig ist es jedoch, wenn sich der Strömungsquerschnitt der Durchlassöffnungen kontinuierlich vom Zentralbereich zum Außenbereich hin ändert.

Hinsichtlich der Ausbildung des Membranelements wurde im Zusammenhang mit der bisherigen Erläuterung der einzelnen Ausführungsbeispiele lediglich beschrieben, dass das Membranelement eine Membran selbst aufweist, eine besonders günstige Ausbildung des Membranelements sieht vor, dass das Membranelement einen Membranträger aufweist, an welchem die Membran gehalten ist.

Um der Membran eine ausreichende Formstabilität zu geben, ist entweder die Membran selbst mit ausreichender Steifigkeit auszuführen oder es ist zweckmäßigerweise vorgesehen, dass die Membran an dem Membranträger gespannt gehalten ist, so dass durch das gespannte Halten der Membran an dem Membranträger deren Formstabilität in ausreichendem Maße sichergestellt werden kann.

Um die Membran gespannt am Membranträger zu halten, ist vorzugsweise vorgesehen, dass der Membranträger eine thermische Ausdehnung aufweist, die der thermischen Ausnehmung der Membran entspricht. Damit ist sichergestellt, dass insbesondere bei in der erfindungsgemäßen Anlage stattfindenden großen Temperaturänderungen die Membran stets an dem Membranträger in gleicher Weise gehalten wird, so dass ein Temperaturwechsel keine Formänderung der Membran, beispielsweise in Form einer Aufwölbung, zur Folge hat.

Besonders günstig ist es dabei, wenn die Membran an dem Membranträger mit Vorspannung fixiert ist, wobei die Vorspannung beispielsweise durch geeigneten Zusammenbau von Membranträger und Membran erzeugt wird.

So ist es beispielsweise denkbar, dass die Membran mit dem Membranträger stoffschlüssig verbunden ist.

Eine andere Lösung sieht vor, dass die Membran an dem Membranträger geklemmt gehalten ist.

Für eine derartige Klemmung der Membran an dem Membranträger ist es von Vorteil, wenn der Membranträger einen Ringkörper aufweist, an welchem die Membran durch Klemmung fixierbar ist.

Eine besonders günstige Lösung sieht vor, dass der Membranträger zwei Ringkörper umfasst, von denen der eine radial innerhalb des anderen liegt, so dass die Membran zwischen den beiden Ringkörpern einklemmbar ist.

Hierzu ist zweckmäßigerweise vorgesehen, dass die zwei Ringkörper in radialer Richtung mit einer Vorspannkraft aufeinander einwirken, um somit zwischen sich die Membran, beispielsweise mit einem Randbereich, einzuklemmen.

Um insbesondere in dem gesamten Temperaturbehandlungsbereich des Substrats die Membran exakt fixiert zu halten, ist vorzugsweise vorgesehen, dass die Ringkörper ein thermisches Ausdehnungsverhalten aufweisen, das derart ist, dass die Ringkörper in einem Temperaturbehandlungsbereich eine thermische Ausdehnung aufweisen, die die radiale Vorspannkraft der Ringkörper aufeinander im Wesentlichen aufrecht erhält, das heißt, dass die Ringkörper sich jeweils in gleicher Weise ausdehnen und somit die einmal vorhandene Vorspannkraft bestehen bleibt.

Hinsichtlich der Ausbildung des Membranträgers wurden im Zusammenhang mit der bisherigen Erläuterung der einzelnen Ausführungsbeispiele ebenfalls keine näheren Angaben gemacht. So könnte grundsätzlich der Membranträger aus einem Material hergestellt sein, das sich von dem der Membran signifikant unterscheidet.

Eine vorteilhafte Lösung sieht dabei vor, dass der Membranträger als Faserverbundwerkstoff ausgebildet ist.

Ein derartiger Faserverbundwerkstoff umfasst einerseits Fasern und andererseits ein Matrixmaterial.

Dabei ist vorteilhafterweise vorgesehen, dass bei einem derartigen Verbundwerkstoff Faserverbundwerkstoff quer zu einem Radius verlaufende Fasern vorgesehen sind.

Besonders günstig ist es, wenn der Faserverbundwerkstoff ein Fasergewebe umfasst.

Um die Stabilität des Membranträgers noch weiter zu verbessern, ist vorzugsweise vorgesehen, dass der Faserverbundwerkstoff mehrere Gewebelagen aufweist.

Im Zusammenhang mit der bisherigen Erläuterung der Ausbildung des Membranelements wurde lediglich definiert, dass das Membranelement mindestens eine Membran und gegebenenfalls einen Membranträger umfasst.

Eine weitere vorteilhafte Ausführung des erfindungsgemäßen Membranelements sieht vor, dass das Membranelement zwei Membranen umfasst.

Bei einem derartigen Membranelement sind zweckmäßigerweise die Membranen mit einem Zwischenraum relativ zueinander angeordnet, so dass die Möglichkeit besteht, beispielsweise in den Zwischenraum Prozessgas oder Kühlgas einzuleiten.

Darüber hinaus betrifft die Erfindung eine Anlage zur thermischen Behandlung von Substraten, insbesondere Halbleitersubstraten, umfassend einen Substrataufnahmeraum und ein auf mindestens einer Seite des Substrataufnahmeraums angeordnetes flächenhaft ausgebildetes Wärmetransferelement, mit welchem das Substrat im Substrataufnahmeraum thermisch behandelbar ist.

Bei einer derartigen Anlage ist erfindungsgemäß vorgesehen, dass das Wärmetransferelement entsprechend einem oder mehreren der voranstehend dargestellten erfindungsgemäßen Merkmale ausgebildet ist.

Ein derartiges erfindungsgemäßes Wärmetransferelement erlaubt es, bei einer Anlage der vorstehend beschriebenen Art, größere Temperaturänderungsgeschwindigkeiten zu realisieren, als sie bislang bei derartigen Anlagen realisiert wurden, bei ausreichender mechanischer Langzeitstandfestigkeit.

Prinzipiell könnte ein derartiges Wärmetransferelement durch mechanischen Kontakt mit einer Heizeinrichtung aufheizbar sein.

Ein derartiger mechanischer Kontakt hätte jedoch den Nachteil, dass damit wiederum aufgrund der Kopplung mit der Heizeinrichtung die Temperaturänderungsgeschwindigkeit negativ beeinträchtigt wäre.

Aus diesem Grund ist vorzugsweise vorgesehen, dass das Wärmetransferelement durch eine Heizeinrichtung mechanisch berührungslos aufheizbar ist.

Prinzipiell könnte der Wärmetransfer zwischen dem Wärmetransferelement und dem Substrat durch Variation des Abstandes zwischen dem Substrat und dem Wärmetransferelement gesteuert werden. Dies hätte jedoch zur Folge, dass eine Relativbewegung derselben erforderlich wäre.

Aus diesem Grund ist vorzugsweise vorgesehen, dass das Wärmetransferelement zeitlich gesteuert aufheizbar ist, so dass das Wärmetransferelement in seiner Relativposition zum Substrat unverändert verbleiben kann und somit die zeitliche Steuerung des Wärmetransfers zwischen dem Wärmetransferelement und dem Substrat über die zeitlich gesteuerte Aufheizung des Wärmetransferelements erfolgt.

Dabei sind unterschiedlichste Möglichkeiten denkbar. Eine vorteilhafte Lösung sieht vor, dass das Wärmestransferelement durch zeitliche Steuerung der Aufheizleistung zeitlich gesteuert aufheizbar ist.

Dies lässt sich beispielsweise dadurch realisieren, dass das Wärmestransferelement entsprechend der zeitlichen Steuerung einer Heizleistung der Heizeinrichtung zeitlich gesteuert aufheizbar ist, das heißt, dass in diesem Fall die thermische Kopplung zwischen der Heizeinrichtung und dem Wärmetransferelement ebenfalls ständig bestehen bleibt und die zeitliche Steuerung durch zeitliche Steuerung der von der Heizeinrichtung erzeugten Heizleistung erfolgt.

Derartige zeitliche steuerbare Heizeinrichtungen können in unterschiedlichster Art und Weise ausgebildet sein. Eine vorteilhafte Lösung sieht vor, dass die Heizeinrichtung Heizlampen umfasst, deren Heizleistung in einfacher Weise durch einen Lampenstrom steuerbar ist.

Eine andere vorteilhafte Lösung sieht vor, dass die Heizeinrichtung einen Induktor umfasst, der ebenfalls hinsichtlich des von diesem erzeugten Magnetfeldes in einfacher Weise steuerbar ist, wobei in diesem Fall der Induktor in dem Wärmetransferelement Wirbelströme erzeugt, die zu einer Aufheizung des Wärmetransferelements führen.

Eine weitere vorteilhafte Lösung sieht vor, dass die Heizeinrichtung eine Mikrowellenquelle umfasst, die hinsichtlich der Mikrowellenleistung steuerbar ist, und das Wärmetransferelement intern aufheizt.

Eine andere Möglichkeit sieht vor, dass das Wärmetransferelement durch zeitliche Steuerung einer Wärmekopplung mit der Heizeinrichtung zeitlich gesteuert aufheizbar ist.

Eine derartige Lösung sieht insbesondere vor, dass die Heizeinrichtung als auf eine konstante Temperatur geregelter Aufheizblock ausgebildet ist, so dass die zeitliche Steuerung über die Wärmekopplung zwischen dem Aufheizblock und dem Wärmetransferelement erfolgt.

Eine derartige zeitliche Steuerung der Wärmekopplung lässt sich beispielsweise dadurch realisieren, dass der Abstand zwischen der Heizeinrichtung und dem Wärmetransferelement verändert wird, wenn zwischen der Heizeinrichtung und dem Wärmetransferelement ein Wärmetransfergas vorgesehen ist.

Um bei der erfindungsgemäßen Anlage nicht nur das Substrat rasch aufheizen zu können, sondern auch die Möglichkeit zu haben, das Substrat kühlen zu können, ist vorzugsweise vorgesehen, dass das Wärmetransferelement zum Abkühlen des Substrats mit einem Kühlgas kühlbar ist.

Ein derartiges Kühlgas ist vorzugsweise auf einer dem Substrat abgewandten Seite der dem Substrat nächstliegenden Membran des Wärmetransferelements zuführbar, so dass eine rasche Abkühlung dieser Membran erfolgt und dadurch die Membran als Wärmesenke für das Substrat dient, so dass damit die Möglichkeit besteht, mittels der Membran dem Substrat Wärme zu entziehen.

Noch besser ist es, wenn das Wärmetransferelement mittels durch dieses hindurchtretende Kühlgas kühlbar ist.

Weitere Merkmale und Vorteile der Erfindung sind Gegenstand der nachfolgenden Beschreibung sowie der zeichnerischen Darstellung einiger Ausführungsbeispiele.

In der Zeichnung zeigen:
- Fig. 1: eine schematische Ansicht eines ersten Ausführungsbeispiels einer Anlage zur thermischen Behandlung von Substraten im Querschnitt;
- Fig. 2: eine ausschnittsweise Draufsicht auf eine Membran eines Wärmetransferelements gemäß dem ersten Ausführungsbeispiel;
- Fig. 3: einen Schnitt längs Linie 3-3 in Fig. 2;

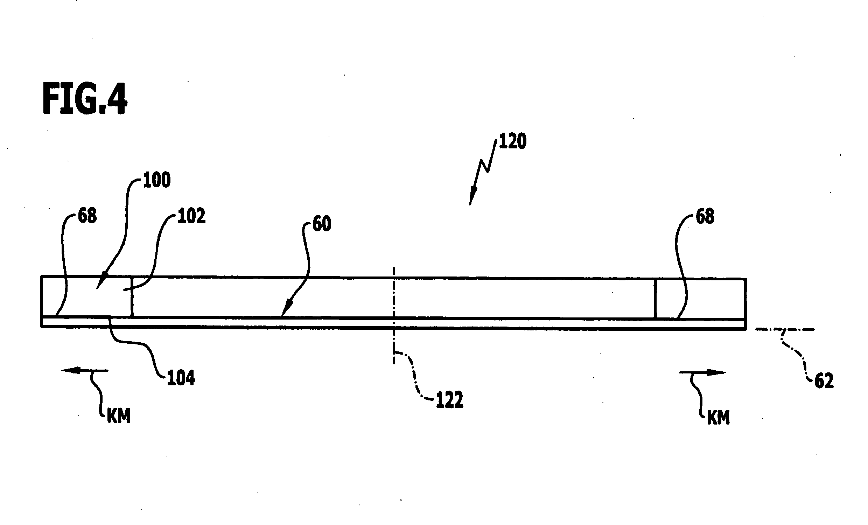

- Fig. 4: einen Schnitt ähnlich Fig. 1 durch ein die Membran umfassendes Membranelement des ersten Ausführungsbeispiels;
- Fig. 5: eine ausschnittsweise Draufsicht auf einen Membranträger des ersten Ausführungsbeispiels;
- Fig. 6: einen Schnitt ähnlich Fig. 4 durch das Membranelement bei einem zweiten Ausführungsbeispiel einer erfindungsgemäßen Anlage;
- Fig. 7: eine Darstellung ähnlich Fig. 2 der Membran bei einem dritten Ausführungsbeispiel einer erfindungsgemäßen Anlage;
- Fig. 8: eine Darstellung ähnlich Fig. 2 der Membran bei einem vierten Ausführungsbeispiel einer erfindungsgemäßen Anlage;
- Fig. 9: einen schematischen Schnitt ähnlich Fig. 1 durch ein fünftes Ausführungsbeispiel einer erfindungsgemäßen Anlage;
- Fig. 10: einen ausschnittsweisen Schnitt ähnlich Fig. 1 durch ein sechstes Ausführungsbeispiel einer erfindungsgemäßen Anlage;
- Fig. 11: eine Darstellung des Membranelements gemäß dem sechsten Ausführungsbeispiel der erfindungsgemäßen Anlage;
- Fig. 12: einen Schnitt ähnlich Fig. 10 durch ein siebtes Ausführungsbeispiel einer erfindungsgemäßen Anlage;
- Fig. 13: einen Schnitt ähnlich Fig. 1 durch ein achtes Ausführungsbeispiel einer erfindungsgemäßen Anlage;
- Fig. 14: einen Schnitt ähnlich Fig. 1 durch ein neuntes Ausführungsbeispiel einer erfindungsgemäßen Anlage;
- Fig. 15: einen Schnitt ähnlich Fig. 1 durch ein zehntes Ausführungsbeispiel einer erfindungsgemäßen Anlage in einem Zustand der Anlage, in welchem eine Aufheizung des Substrats erfolgt;
- Fig. 16: einen Schnitt ähnlich Fig. 15 durch das zehnte Ausführungsbeispiel der erfindungsgemäßen Anlage, in einem Zustand, in welchem eine Abkühlung des Substrats erfolgt und
- Fig. 17: einen Schnitt ähnlich Fig. 16 durch ein elftes Ausführungsbeispiel einer erfindungsgemäßen Anlage.

Ein erstes Ausführungsbeispiel einer erfindungsgemäßen Anlage 10 zur thermischen Behandlung eines Substrats 12 umfasst ein Außengehäuse 20, in dessen Innenraum 22 im Abstand vom Außengehäuse 20 ein Innengehäuse 24 angeordnet ist, welches aus einem für Wärmestrahlung transparenten Material hergestellt ist und einen Substrataufnahmeraum 30 umschließt, der zur Aufnahme des Substrats 12 dient.

Das Substrat 12 wird mit dem Substrataufnahmeraum 30 durch einen Substratträger 32 gehalten, welcher teller- oder plattenähnlich ausgebildet ist und mehrere, beispielsweise drei Stützelemente 34, aufweist, auf deren Spitzen 36 das Substrat 12 im Substrataufnahmeraum 30 aufliegt.

Vorzugsweise ist dabei der Substratträger 32 an einer Welle 38 gehalten und dabei um eine Achse 40 drehbar, so dass das auf den Spitzen 36 der Stützelemente 34 ruhende Substrat 12 ebenfalls mitdrehbar ist.

Hierzu ist die Welle 38 mit einem als Ganzes mit 42 bezeichneten Antrieb verbunden, der beispielsweise außerhalb des Außengehäuses 20 angeordnet ist.

Durch den Substratträger 32 mit den Stützelementen 34 wird das Substrat in dem in einem mittigen Bereich innerhalb des Innengehäuses 24 vorgesehenen Substrataufnahmeraum 30 so gehalten, dass dieses sich mindestens ungefähr senkrecht zur Achse 40 und ungefähr parallel zum Substratträger 32, vorzugsweise in einer Ebene 44, erstreckt.

Ferner wird das Substrat 12 vorzugsweise so auf den Stützelementen 34 des Substratträgers 32 gehalten, dass die Spitzen 36 an einer Unterseite 46 des Substrats 12 anliegen, während eine Oberseite 48 des Substrats 12 keine Berührung seitens des Substratträgers 32 oder der Stützelemente 34 erfährt.

Vorzugsweise ist das Substrat 12 im Bereich seiner Oberseite 48 mit Strukturen 50 versehen, im Bereich von welchen primär eine thermische Behandlung erfolgen soll, um beispielsweise chemische Reaktionen oder Diffusionsprozesse durch die Temperaturführung der thermischen Behandlung gezielt stattfinden zu lassen.

Beispielsweise handelt es sich bei dem Substrat 12 um ein Halbleitersubstrat, insbesondere einen Halbleiterwafer, der im Bereich seiner Oberseite 48 Strukturen 50, die eine Zwischenstufe in einem Herstellungsprozess des Halbleiterchips darstellen, aufweist, wobei aus dieser Zwischenstufe dann durch die thermische Behandlung entweder eine weitere Zwischenstufe oder das Endprodukt, nämlich ein Halbleiterchip mit einer bestimmten Struktur und einer bestimmten Dotierung, herstellbar ist.

Die thermische Behandlung der Strukturen 50 erfolgt insbesondere in Form sogenannter schneller thermischer Behandlungen, das heißt schnell wechselnder Behandlungen, wobei ein derartiger schneller Wechsel der thermischen Behandlung es erlaubt, gezielt chemische Reaktionen und/oder Diffusionsprozesse zu steuern, in dem ein unteres Temperaturniveau, ab welchem die chemische Reaktion oder der Diffusionsprozess einsetzt, für einen definiert vorgebbaren Zeitraum überschritten wird, wobei in dem definierten vorgebbaren Zeitraum dann ein Temperaturverlauf, gemäß welchem die untere Schwelle überschritten wird, festlegbar ist.

Hierzu erfolgt zumindest im Bereich der mit den Strukturen 50 versehenen Oberseite 48 des Substrats eine Aufheizung desselben über ein Wärmetransferelement 52, welches eine Membran 60 umfasst, die sich in einer Fläche 62 erstreckt, welche ungefähr parallel zur Fläche 44 verläuft.

Die Membran 60 dient bei dem ersten Ausführungsbeispiel im Hinblick auf die Aufheizung des Substrats 12 im Bereich der Strukturen 50 auf der Oberseite 48 desselben als Wärmestrahler, und arbeitet beispielsweise mit einem Wärmestrahlungsspektrum entsprechend einem grauen oder schwarzen Strahler, dessen Temperatur beispielsweise ungefähr gleich oder geringfügig höher gewählt wird als die Temperatur, auf welche das Substrat 12 im Bereich der Oberfläche 48 aufgeheizt werden soll, um bei dem Substrat 12 aufgrund unterschiedlich emittierender Oberflächen desselben den sogenannten "pattern effect" möglichst weitgehend zu vermeiden und zumindest die Oberseite 48 des Substrats 12 im Bereich der Strukturen 50 mit möglichst geringem oberflächlichem Temperaturunterschied aufzuheizen.

Beispielsweise erfolgt ein Aufheizen des Substrats über einen unteren Schwellwert von ungefähr 700°C auf einen Maximalwert, der im Bereich zwischen 800°C und 1200°C liegt, so dass die Membran 60 eine Temperatur aufweist, die höher liegt, beispielsweise um einen Wert im Bereich von 0 K bis ungefähr 100 K.

Die Membran 60 erstreckt sich dabei in einem Abstand von maximal ungefähr 1 cm von der Oberfläche 48 des Substrats 12, um das Substrat 12 im Bereich der Oberfläche 48 optimal aufheizen zu können.

Ferner liegt die Membran 60 innerhalb des Innengehäuses 24 und ist an diesem über Membranhalter 64 gehalten.

Vorzugsweise begrenzt die Membran 60 mit einer Vorderseite 66 den Substrataufnahmeraum 30 auf einer Seite, während auf einer gegenüberliegenden Seite der Substrataufnahmeraum 30 durch den Substratträger 32 begrenzt ist.

Zum Aufheizen der Membran 60 sind die unterschiedlichsten Möglichkeiten denkbar.

Bei dem ersten Ausführungsbeispiel erfolgt ein Aufheizen der Membran 60 durch außerhalb des Innengehäuses 24 angeordnete Lampen 70, beispielsweise Halogenstrahler, welche Heizwendeln 72 aufweisen, die auf eine Temperatur im Bereich zwischen ungefähr 2600 K und ungefähr 3000 K aufheizbar sind.

Die Strahlung dieser Lampen 70 durchsetzt das aus einem für diese Strahlung transparenten Material gebildete Innengehäuse 24 und wird von der Membran 60 absorbiert, so dass dadurch ein Aufheizen der Membran 60 erfolgt.

Hierzu ist bei dem ersten Ausführungsbeispiel die Membran 60 auf ihrer Rückseite 68 vorzugsweise mit einer Beschichtung 74 versehen, welche aus einem Material mit einer geeigneten Dicke hergestellt ist, das eine optimale Absorption der Strahlung der Lampen 70 gewährleistet, insbesondere die Strahlung der Lampen 70 möglichst wenig reflektiert.

Um ferner eine optimale thermische Abstrahlung der Membran 60 zu erreichen, ist vorzugsweise die Membran 60 auf ihrer Vorderseite 66 ebenfalls mit einer Beschichtung 76 versehen, die eine optimale Abstrahlung in Richtung der Oberseite 48 des Substrats 12 ermöglicht.

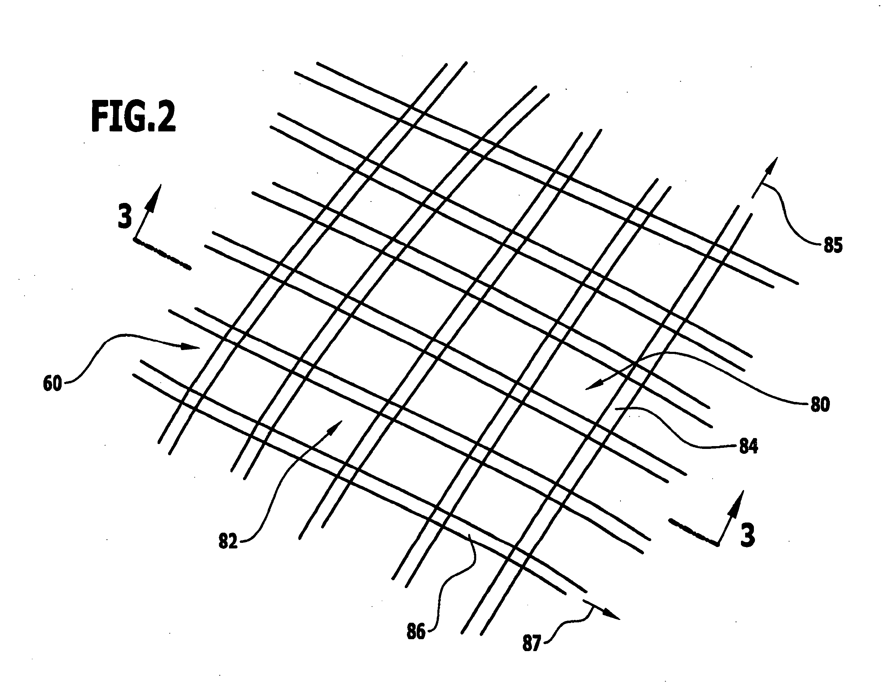

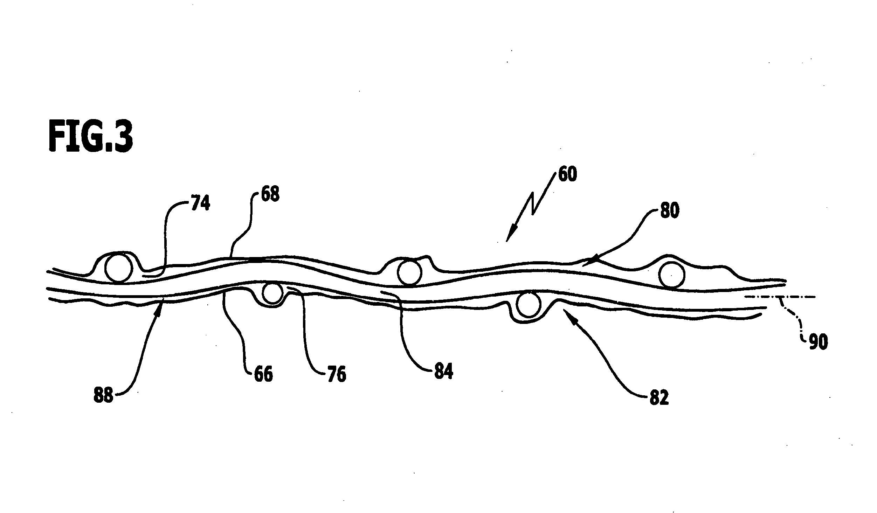

Wie in Fig. 2 und 3 dargestellt, umfasst die Membran 60 beim ersten Ausführungsbeispiel eine Matte 80, die aus einem Gewebe 82 gebildet ist, wobei das Gewebe 82 ungefähr parallel zu einer ersten Richtung 85 verlaufende erste Fasern 84 und ungefähr parallel zu einer zweiten Richtung 87 verlaufende zweite Fasern 86 aufweist, die somit kreuzend zueinander verlaufen und miteinander verwoben sind, so dass in dem Gewebe 82 die Fasern 84 und 86 relativ zueinander fixiert sind.

Beispielsweise umfasst die Matte 80 eine einzige Gewebelage 88, das heißt eine Lage von sich in einer Lagenfläche 90 erstreckende Fasern 84 und eine Lage von sich in der Lagenfläche 90 erstreckenden Fasern 86, die in Kreuzungsbereichen übereinander verlaufen.

Die Fasern 84 und 86 können dabei aus unterschiedlichen Materialien hergestellt sein, so lange diese Materialien hochtemperaturbeständig und hitzeschockresistent sind.

Im Rahmen der vorliegenden Erfindung wird unter dem Begriff hochtemperaturbeständig eine Temperaturbeständigkeit gegenüber Temperaturen von mehr als 700°C, besser mehr als 900°C und noch besser mehr als 1200°C verstanden.

Ferner wird unter dem Begriff Thermoschockresistenz eine Schockresistenz der Fasern 84 und 86 gegenüber Temperaturänderungen um mehr als 500°K in weniger als einer Sekunde, noch besser mehr als 700°K in weniger als einer Sekunde verstanden, die insbesondere dadurch entsteht, dass die Faser oder auch ein Faserverbundwerkstoff typischerweise einen kleinen Wärmeausdehnungskoeffizienten aufweisen.

Die Fasern 84 und 86 sind bei einer beispielhaften Ausführungsform als Kohlenstofffasern ausgebildet.

Alternativ dazu ist es denkbar, die Fasern 84 und 86 aber auch als Siliziumcarbid-Fasern auszubilden oder aus Fasern eines anderen Keramikmaterials.

Es ist aber auch denkbar, für ein und dasselbe Gewebe Fasern 84 aus einem ersten Material und Fasern 86 aus einem zweiten Material einzusetzen oder selbst innerhalb der Fasern 84 Fasern aus unterschiedlichen Materialien zu verwenden.

Bei dem erfindungsgemäßen Ausführungsbeispiel kann die Membran 60 ausschließlich aus der Lage 88 von Gewebe 82 aufgebaut sein.

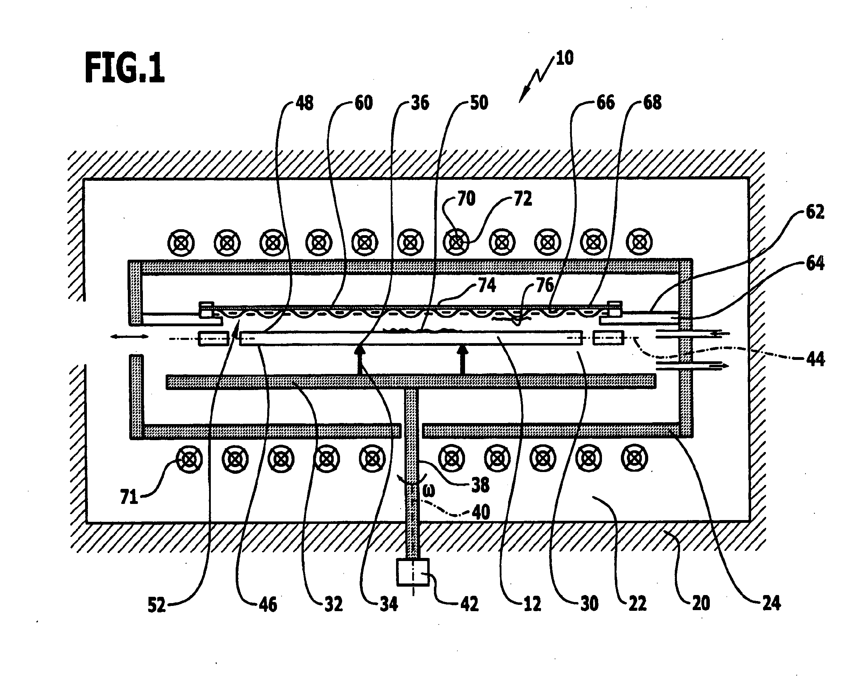

Wie bereits im Zusammenhang mit Fig. 1 erläutert, ist jedoch vorteilhafterweise die Membran 60 auf ihrer Vorderseite 66 mit der Beschichtung 76 versehen, welche die Fasern 84 und 86 überzieht und auf der Rückseite 68 mit der Beschichtung 74, welche in diesem Bereich ebenfalls die Fasern 84 und 86 überzieht.

Die Beschichtungen 76 und 74 können aus unterschiedlichen Materialien zusammengesetzt sein und auch durch unterschiedliche Prozesse aufgetragen sein.

Beispielsweise kommen als Materialien für die Beschichtungen Siliziumnitrid und/oder Siliziumcarbid in Frage, die entweder durch Plasmaspritzen und/oder durch PVD (Physical Vapor Deposition) und/oder durch CVD (Chemical Vapor Deposition) und/oder durch CVI (Chemical Vapor Infiltration) auftragbar sind.

Besonders zweckmäßig ist es, wenn die Beschichtungen durch PVD oder CVD aufgetragen sind. Bei CVD oder CVI setzt sich einerseits das Beschichtungsmaterial in Risse und Vertiefungen und weist andererseits nach Auftragen der Beschichtungen die Membran 60 ein hohes Maß an Sauberkeit auf.

Die Beschichtungen 74 und 76 haben vorzugsweise eine Dicke, die im Bereich zwischen ungefähr 10 nm (100 Ä) und ungefähr 300 nm (3000 Ä) liegt.

Ferner ist es für eine schnelle thermische Behandlung, das heißt ein schnelles Aufheizen und ein schnelles Abkühlen von entscheidender Bedeutung, dass die Membran 60 eine geringe Wärmespeicherkapazität oder thermische Masse aufweist, so dass sich die Membran 60 einerseits schnell aufheizen lässt und andererseits aber nach Abbruch des Aufheizprozesses von selbst schnell auskühlt, da bei geringer thermischer Masse der Membran 60 auch die in dieser gespeicherte Wärmemenge gering ist.

Vorzugsweise hat dabei die Membran 60 eine Dicke, die mindestens 0,07 mm beträgt, beispielsweise in dem Fall, dass eine einzige Lage 88 von Fasern 84, 86 eingesetzt wird.

Eine sinnvolle maximale Dicke der Membran 60 liegt, insbesondere beim Verwenden mehrerer Matten 80 bei weniger als 1,5 mm, besser weniger als 1 mm, noch besser weniger als 0,5 mm.

Vorteilhafterweise lassen sich schnelle thermische Wärmebehandlungsprozesse dann erreichen, wenn die thermische Masse der Membran 60 weniger als 50 % des Substrats 12, noch besser weniger als 30 % des Substrats 12 beträgt.

Die Beschichtungen 74 und 76 können bei der erfindungsgemäßen Membran 60 nicht nur dazu eingesetzt werden, vorteilhafte strahlungsabsorbierende und strahlungsemittierende Eigenschaften zu erreichen, sondern auch dazu, die Fasern 84 und 86 zu schützen, nämlich dadurch, dass die Beschichtungen 74 und 76 insgesamt die Fasern 84 und 86 umfangsseitig überdecken.

Darüber hinaus besteht die Möglichkeit, durch die Beschichtungen 74 und 76 auch die Fasern 84 und 86, die kreuzend zueinander verlaufen, relativ zueinander im Bereich ihrer Kreuzungsbereiche zu fixieren, da die Beschichtungen 74 und 76 sich sowohl an den Fasern 84 als auch an den Fasern 86 fest haften.

Um die Membran 60 in einfacher Weise einbauen und beispielsweise an den Membranhaltern 64 im Innengehäuse 24 fixieren zu können, ist vorzugsweise vorgesehen, dass die Membran 60 fest mit einem Membranträger 100 verbunden ist, welcher beispielsweise als Trägerring 102 ausgebildet ist, an dessen einer Flachseite 104 die Membran 60, beispielsweise mit ihrer Rückseite 68 fixiert ist. Die Fixierung kann beispielsweise durch Ausbildung einer stoffschlüssigen Fügeverbindung erfolgen, beispielsweise durch Auftragen und Aufschmelzen von Silizium, das sowohl an dem Trägerring 102 als auch an der Membran 60 haftet.

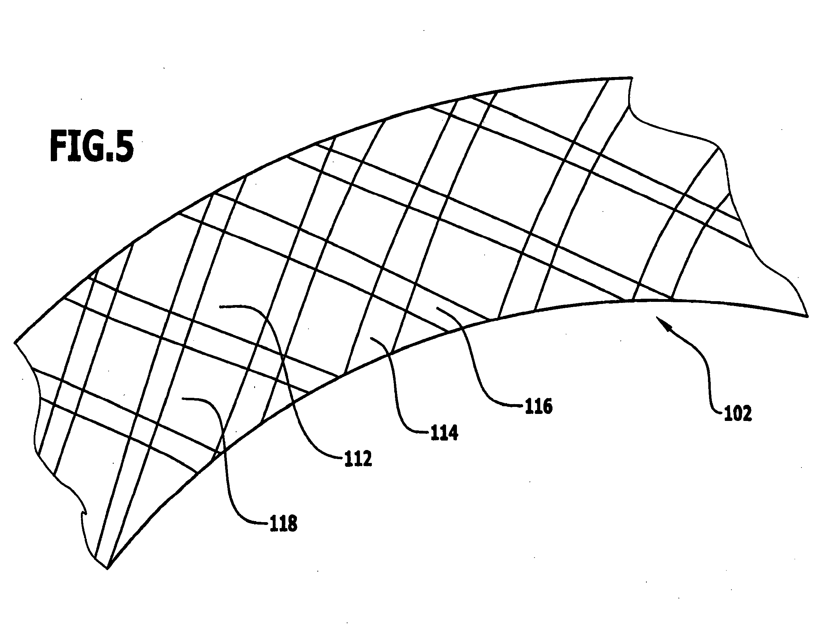

Der Trägerring 102 ist, wie beispielsweise in Fig. 5 dargestellt, vorzugsweise ebenfalls aus einem Gewebe 112 aus Fasern 114 und 116 ausgebildet, wobei die Fasern 114 und die Fasern 116 kreuzend zueinander verlaufen.

Ferner sind die Fasern 114 und 116 in eine Matrix 118 eingebettet, so dass der Trägerring 102 insgesamt als Verbundkörper ausgebildet ist.

Wenn die Fasern 114 und 116 im Trägerring 102 dieselbe thermische Ausdehnung aufweisen wie die Fasern 84 und 86 der Membran 60, lässt sich aus der Membran 60 und dem Trägerring 102 ein Membranelement 120 ausbilden, bei welchem in Richtung parallel zur Fläche 62 die thermische Ausdehnung des Trägerrings 102 im Wesentlichen identisch ist mit der thermischen Ausdehnung der Membran 60, so dass der Trägerring 102, der die Membran 60 trägt, die Membran 60 stets im Wesentlichen in Richtung der Fläche 62 mit der gleichen Kraft KM, welche radial zu einer Mitte 122 des Membranelements 120 verläuft, gespannt hält, sofern die Membran 60 unter einer Vorspannung mit der Kraft KM an dem Trägerring 102 fixiert wird.

Ein derartiges Fixieren unter Vorspannung lässt sich beispielsweise auch dadurch erreichen, dass eine Fügeverbindung zwischen der Membran 60 und dem Trägerring 102 bei unterschiedlichen Temperaturen von Trägerring 102 und Membran 60 erfolgt, so dass nach dem Temperaturausgleich zwischen dem Trägerring 102 und der Membran 60 die Membran 60 mit der definierten Vorspannung KM am Trägerring 102 fixiert ist.

Aufgrund der im Wesentlichen identischen thermischen Ausdehnung des Trägerrings 102 und der Membran 60 wird die einmal dann erreichte Vorspannung im Wesentlichen auch bei großen Temperaturänderungen, wie sie bei der erfindungsgemäßen Anlage entstehen, aufrecht erhalten.

Alternativ dazu lässt sich ein Spannen der Membran 60 durch den Trägerring 102 auch dadurch erreichen, dass der Trägerring 102 nicht als reiner C/C Verbundwerkstoff aufgebaut wird, sondern dass in diesen die Einlagerung von Siliziumcarbid erfolgt.

Da Siliziumcarbid eine größere Wärmeausdehnung aufweist als der Kohlenstoff lässt sich damit erreichen, dass sich der Trägerring 102 in radialer Richtung zur Mitte 122 des Membranelements 120 bei Erreichen des relevanten Temperaturbereichs von mehreren 100°C stärker ausdehnt als die Membran 60 und dadurch die radialen Kräfte KM entstehen, die die Membran 60 bei Temperaturen von mehreren 100°C gespannt halten.

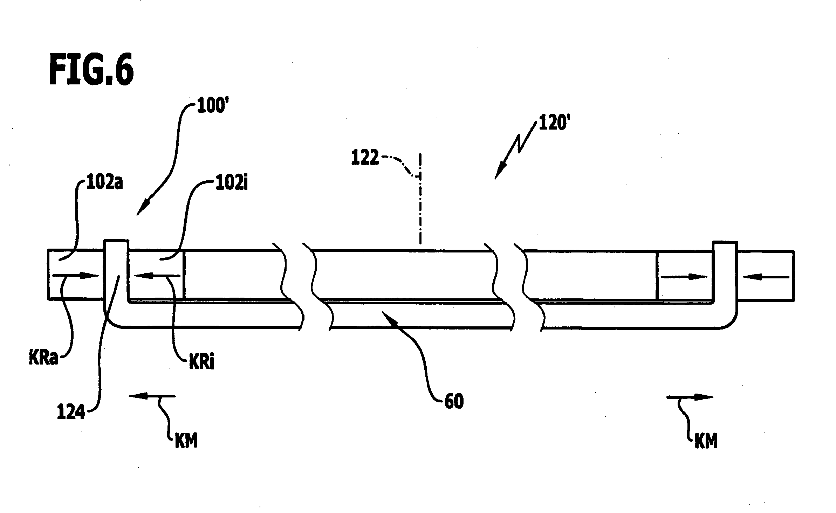

Bei einem zweiten Ausführungsbeispiel eines erfindungsgemäßen Membranelements 120', dargestellt in Fig. 6, ist nicht nur ein Trägerring 102 als Membranträger 100' vorgesehen, sondern der Membranträger 100' ist gebildet durch einen inneren Trägerring 102i und einen äußeren Trägerring 102a, zwischen denen ein Randbereich 124 der Membran 60 dadurch eingeklemmt ist, dass der inneren Trägerring 102i mit einer radialen Kraft KRi radial zur Mitte 122 nach außen gerichtet wirkt, während der äußere Trägerring 102a mit einer radialen Kraft KRa radial nach innen zur Mitte 122 hin wirkt, so dass der Randbereich 124 der Membran 60 kraftschlüssig zwischen dem inneren Trägerring 102i und dem äußeren Trägerring 102a eingeklemmt ist.

Auch bei dieser Lösung lässt sich zusätzlich noch ein Spannen der Membran 60 dann erreichen, wenn insgesamt auf die Membran 60 in gleicher Weise wie beim ersten Ausführungsbeispiel die Kräfte KM in radialer Richtung zur Mitte 122 nach außen hin wirken, beispielsweise dadurch, dass insgesamt der Membranträger 100' die Membran 60 mit Vorspannung und somit mit existierenden Kräften KM aufnimmt, was beispielsweise durch Zusammenbau der Trägerringe 102i und 102a sowie der Membran 60 bei unterschiedlichen Temperaturen erreicht werden kann oder dadurch, dass die Trägerringe 102i und 102a eine größere thermische Ausdehnung aufweisen als die Membran 60, so dass bei den Temperaturen von mehreren 100°C bei denen die erfindungsgemäße Anlage arbeitet, aufgrund der größeren Ausdehnung des Membranträgers 100 die Membran 60 von diesem gespannt gehalten wird.

Im Übrigen ist das zweite Ausführungsbeispiel in gleicher Weise ausgebildet wie das erste Ausführungsbeispiel, so dass diesbezüglich auf die Ausführungen zum ersten Ausführungsbeispiel vollinhaltlich Bezug genommen werden kann.

Bei einem dritten Ausführungsbeispiel einer erfindungsgemäßen Anlage ist die Membran 60' nicht lediglich aus den Fasern 84 und 86 aufgebaut, sondern zusätzlich zu den Fasern 84 und 86 ist ein die Fasern 84 und 86 umgebendes Matrixmaterial 126 vorgesehen, welches die Fasern 84 und 86 relativ zueinander fixiert.

Im Fall von Kohlenstofffasern oder Carbonfasern 84 und 86 kann das Matrixmaterial 126 dabei Kohlenstoff sein, dass durch Pyrolyse eines die Fasern 84 und 86 einbettenden Harzmaterials entstanden ist. Es ist aber auch denkbar, dass dieses Matrixmaterial 126 durch zusätzliche Silizierung ganz oder zumindest teilweise in Siliziumcarbid umgewandelt wird. In diesem Fall erfolgt zumindest auch oberflächlich der Fasern 84 und 86 die Ausbildung von Siliziumcarbid.

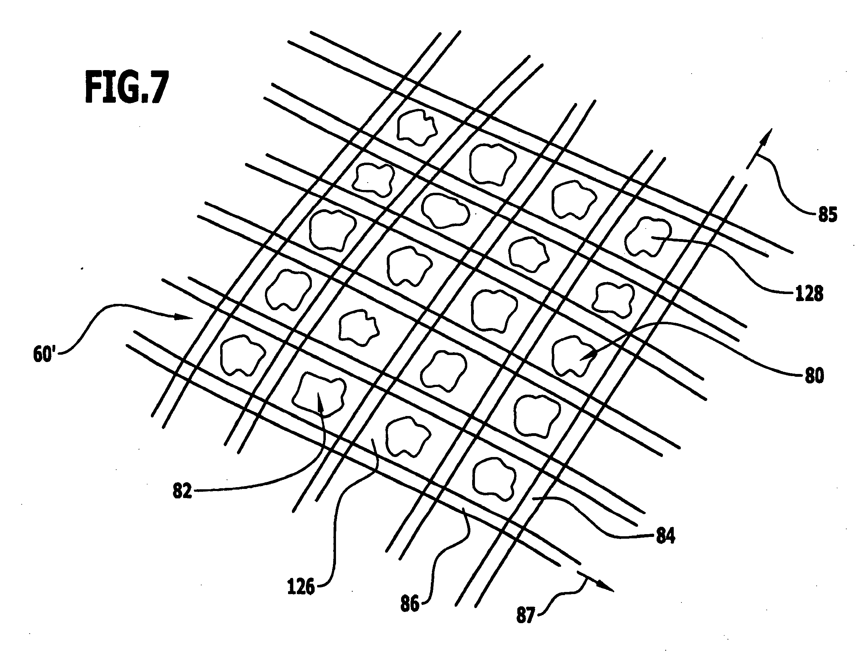

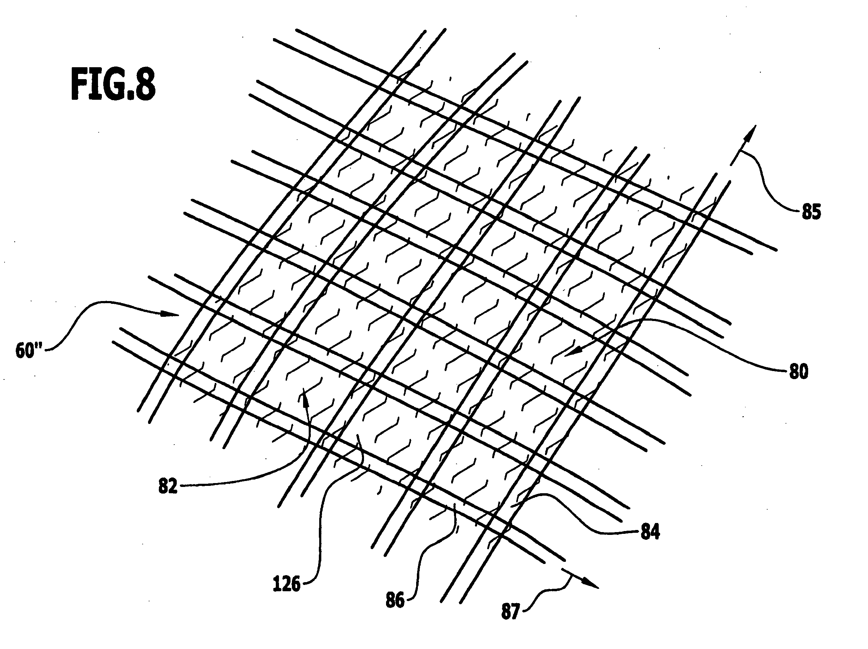

Dabei kann das Matrixmaterial 126 so gewählt sein, dass zwischen den Fasern 84 und 86, wie in Fig. 7 dargestellt, noch Öffnungen 128 vorhanden sind, so dass die Membran 60' für ein Medium durchlässig ist oder der Anteil des Matrixmaterials 126 kann derart erhöht sein, dass keine Öffnungen 128 mehr zwischen den Fasern 84 und 86 bestehen, wie bei dem vierten Ausführungsbeispiel gemäß Fig. 8 dargestellt.

Im Übrigen ist auch das dritte Ausführungsbeispiel in gleicher Weise ausgebildet wie die voranstehenden Ausführungsbeispiele, so dass hinsichtlich der übrigen, im Zusammenhang mit dem dritten Ausführungsbeispiel nicht beschriebenen Merkmale, vollinhaltlich auf die Ausführungen zu den voranstehenden Ausführungsbeispielen Bezug genommen wird.

Bei diesem vierten Ausführungsbeispiel, dargestellt in Fig. 8 füllt das Matrixmaterial 126 die Zwischenräume zwischen den Fasern 84 und 86 im Wesentlichen vollständig aus, wobei allerdings das Matrixmaterial 126 dann, wenn dieses reiner Kohlenstoff ist, aufgrund der Pyrolyse von Harzmaterial selbst porös sein kann und noch ein gewisses Maß an Durchlässigkeit für ein Fluid hat. Diese Durchlässigkeit für ein Fluid lässt sich jedoch unterbinden beispielsweise durch Silizierung unter Bildung von Siliziumcarbid und Auffüllen der Poren durch freies Silizium.

Die Durchlässigkeit für ein Fluid lässt sich aber auch dadurch unterbinden, dass die Membran 60" gemäß dem vierten Ausführungsbeispiel mit Beschichtungen, beispielsweise den Beschichtungen 74 und 76 versehen wird, die aus derartigen Materialien hergestellt werden können, dass diese die Poren der Matrix 126 verschließen.

Bei den bislang beschriebenen Ausführungsbeispielen wurde primär darauf eingegangen, wie das Substrat 12 auf seiner Oberseite 48 im Bereich der Strukturen 50 aufgeheizt werden kann.

Es wurde jedoch nichts darüber ausgeführt, inwieweit eine Aufheizung des Substrats 12 im Bereich seiner Unterseite 46 erfolgt.

Bei dem ersten Ausführungsbeispiel sind, wie in Fig. 1 dargestellt, auch der Unterseite 46 zugewandte Lampen 71 zwischen dem Außengehäuse 20 und dem Innengehäuse 24 angeordnet, welche in Richtung der Unterseite 46 des Substrats 12 strahlen und damit auch das Substrat 12 von der Unterseite ausgehend aufheizen.

Um dies zu erreichen ist der sich zwischen den Lampen 71 und der Unterseite 46 des Substrats 12 vorgesehene Substratträger 32 aus dem selben Material ausgebildet wie die Wand des Innengehäuses 24 und damit für die Strahlung der Lampen 71 im Wesentlichen transparent, um keine Strahlung zu absorbieren.

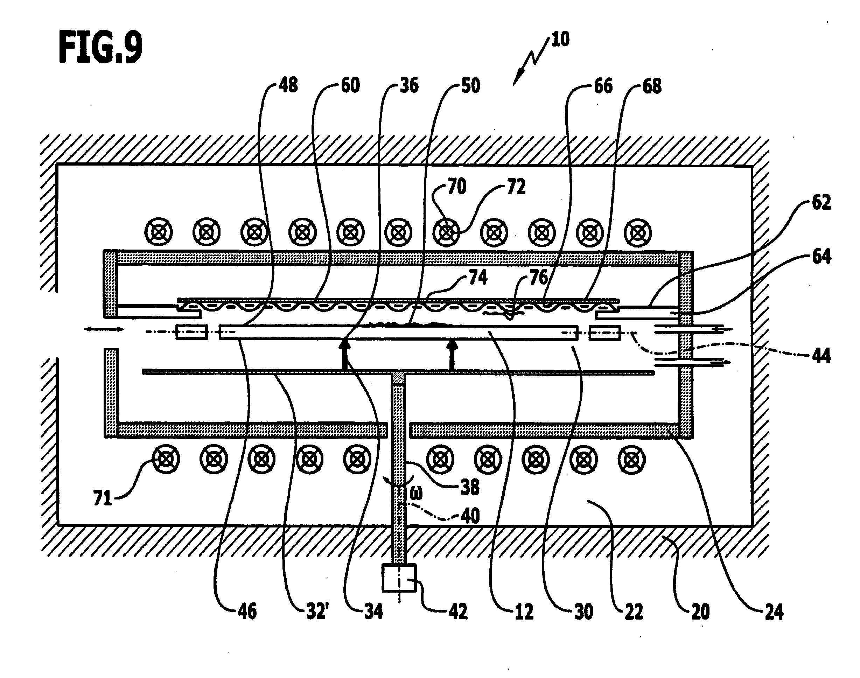

Bei einem fünften Ausführungsbeispiel, dargestellt in Fig. 9, ist im Gegensatz zum ersten Ausführungsbeispiel der Substratträger 32' nicht aus einem für die Strahlung der Lampen 71 transparenten Material ausgebildet, sondern in gleicher Weise ausgebildet wie die Membran 60, so dass der Substratträger 32' ebenfalls als Wärmetransferelement wirkt und die Strahlung der Lampen 71 absorbiert und selbst wiederum aufgrund seiner Temperatur in Richtung der Unterseite 46 des Substrats Wärmestrahlung abgibt, so dass auch im Bereich der Unterseite 46 des Substrats 12 die Möglichkeit besteht, den "pattern effect" zu vermeiden.

In diesem Fall hat somit der Substratträger 32' eine doppelte Funktion, er dient einerseits zum Abstützen des Substrats 12 und andererseits wirkt er in gleicher Weise wie die Membran 60 zur Aufheizung des Substrats 12.

Im Übrigen ist auch das fünfte Ausführungsbeispiel in gleicher Weise ausgebildet wie die voranstehenden Ausführungsbeispiele, so dass hinsichtlich der Beschreibung der übrigen Merkmale vollinhaltlich auf die Ausführungen zu den voranstehenden Ausführungsbeispielen Bezug genommen wird.

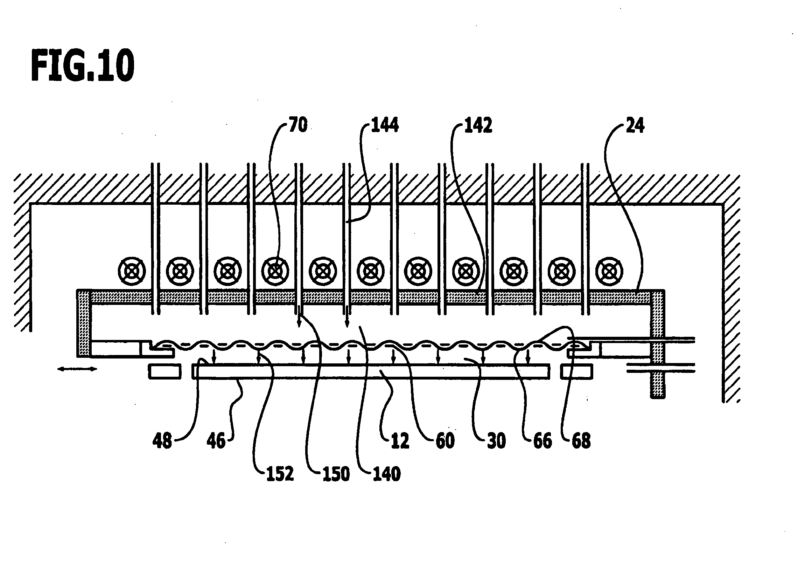

Bei einem sechsten Ausführungsbeispiel, dargestellt in Fig. 10, ist die Membran 60 gemäß dem ersten Ausführungsbeispiel, dargestellt in Fig. 2 und 3, oder gemäß dem dritten Ausführungsbeispiel, dargestellt in Fig. 7, ausgebildet, das heißt, dass die Membran 60 für ein Fluid durchlässig ist.

Dies erlaubt beispielsweise in einen Zwischenraum 140 zwischen der Rückseite 68 der Membran 60 und einer dieser zugewandten Wand 142 des Innengehäuses 24 über Zuleitungen 144, die beispielsweise zwischen den Lampen 70 hindurchverlaufen und die Wand 142 durchsetzen, während der Wärmebehandlung des Substrats 12 oder am Ende der Wärmebehandlung des Substrats 12 einen Gasstrom 150 einzuführen, der entweder ein während der thermischen Behandlung benutztes Prozessgas umfasst oder nach Beendigung der thermischen Behandlung des Substrats eine möglichst rasche Abkühlung einerseits der Membran 60 und andererseits des Substrats 12 erlaubt.

Es besteht die Möglichkeit, die Öffnungen 128 so zu dimensionieren, dass der über die Zuleitungen 144 in den Zwischenraum 140 eintretende Gasstrom 150 die Membran 60 durchsetzt und als durch die Membran 60 im Wesentlichen homogener diffuser Gasstrom 152 in den Substrataufnahmeraum 30 eintritt, um in diesem Prozessgas zuzuführen oder das Substrat 12 zu kühlen.

Im Übrigen ist auch das sechste Ausführungsbeispiel bezüglich der nicht im Einzelnen beschriebenen Merkmale in gleicher Weise ausgebildet wie die voranstehenden Ausführungsbeispiele, so dass diesbezüglich auf die Ausführungen zu den voranstehenden Ausführungsbeispielen vollinhaltlich Bezug genommen wird.

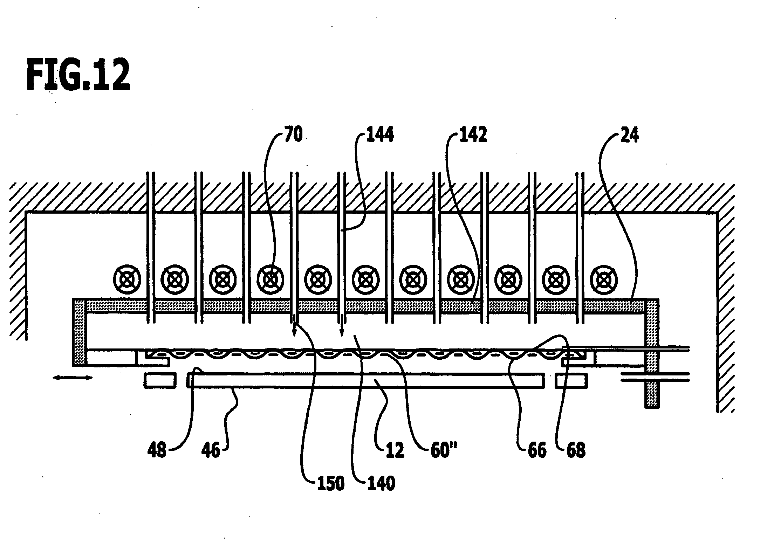

Im Gegensatz dazu ist bei einem siebten Ausführungsbeispiel, dargestellt in Fig. 12 die Membran 60" gemäß dem dritten Ausführungsbeispiel, dargestellt in Fig. 8, ausgeführt und dabei fluiddicht ausgebildet, so dass ein in den Zwischenraum 140 durch die Zuleitungen 144 eintretender Gasstrom 150 nicht das Substrat 12 erreichen kann.

Bei diesem Ausführungsbeispiel besteht somit die Möglichkeit, nach Abschalten der Lampen 70 die Membran 60" mittels des Gasstroms 150 rasch abzukühlen, um die Aufheizung des Substrats 12 durch die Membran 60" möglichst rasch zu beenden und bei weiterer Kühlung der Membran 60" von dem Substrat 12 abgestrahlte Wärmestrahlung zusätzlich zu absorbieren, so dass dadurch insgesamt die Abkühlung des Substrats 12 nach Beendigung der Aufheizung desselben schneller erfolgen kann.

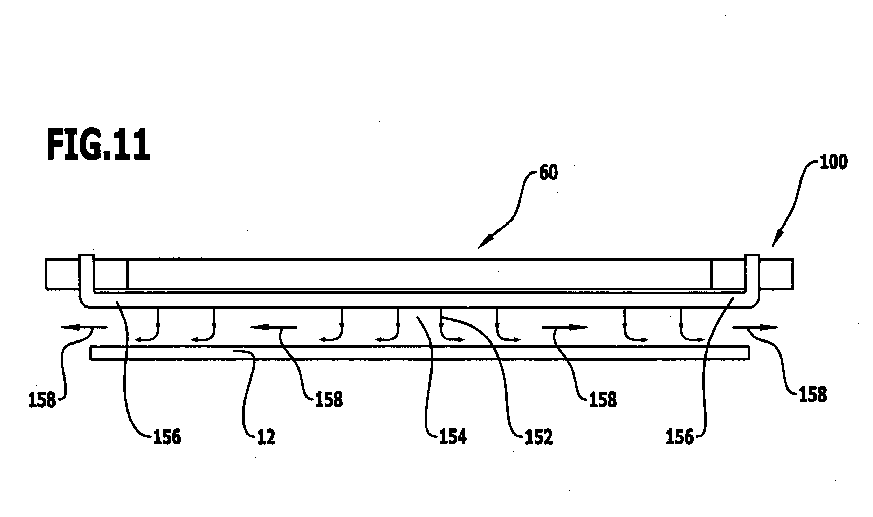

Vorzugsweise variieren, wie in Fig. 11 dargestellt, die Öffnungen 128 in ihrem Strömungsquerschnitt für den Gasstrom 152 so, dass beispielsweise in einem Zentralbereich 154 der Membran 60' der Strömungsquerschnitt der Öffnungen 128 einen Maximalwert aufweist und in einem Außenbereich 156 der Membran 60' einen Minimalwert aufweist.

Dabei variiert der Strömungsquerschnitt 128 vorzugsweise derart, dass dieser im Außenbereich 156 um mehr als einen Faktor 2, vorzugsweise um ungefähr einen Faktor 3 kleiner ist als im Zentralbereich 154.

Eine besonders günstige Lösung sieht vor, dass sich der Strömungsquerschnitt der Öffnungen 128 vom Zentralbereich 154 der Membran ausgehend bis zum Außenbereich 156 kontinuierlich, vorzugsweise linear in dem angegebenen Maße ändert.

Damit lässt sich in dem Substrataufnahmeraum 30 zwischen der Membran 60' und dem Substrat 12 der homogene diffuse Gasstrom 152 so ausbilden, dass eine eine Strömungsgeschwindigkeit desselben radial vom Zentralbereich 154 nach außen zu den Außenbereichen 156 hin mindestens näherungsweise gleich groß ist, wobei das Gas in radialer Richtung 158 zwischen der Membran 60' und dem Substrat nach außen strömt und dann weiter in dieser Richtung 158 aus dem Substrataufnahmeraum 30 abströmt.

Im Übrigen ist auch das siebte Ausführungsbeispiel hinsichtlich der nicht im Detail beschriebenen Merkmale in gleicher Weise ausgebildet wie die voranstehenden Ausführungsbeispiele, so dass diesbezüglich auf die Ausführungen zu den voranstehenden Ausführungsbeispielen Bezug genommen wird.

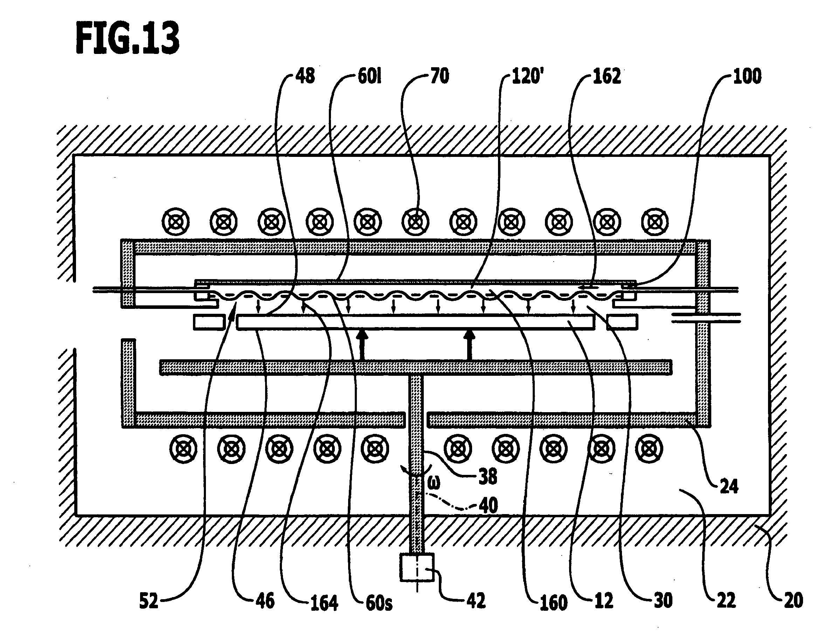

Bei einem achten Ausführungsbeispiel, dargestellt in Fig. 13 ist als primäre Wärmequelle 52 ein Membranelement 120' vorgesehen, bei welchem der Membranträger 100 eine substratseitige Membran 60s sowie eine lampenseitige Membran 601 trägt, zwischen welchen ein Zwischenraum 160 besteht. Bei diesem Membranelement wird von den Lampen 70 die lampenseitige Membran 601 zunächst aufgeheizt, die dann ihrerseits abstrahlt und die substratseitige Membran 60s aufheizt, wobei die substratseitige Membran 60s dann aufgrund ihrer Strahlung das Substrat 12 im Bereich seiner Oberseite 48 aufheizt.

Ferner ist bei diesem Membranelement 120' die substratseitige Membran 60s so ausgebildet, dass diese für ein Medium durchlässig ist, so dass die Möglichkeit besteht, in den Zwischenraum 160 einen Gasstrom 162 einzuführen, welcher sich in dem Zwischenraum 160 verteilt und dann dazu führt, dass dieser zumindest insoweit, als er durch die Membran 60s hindurchtritt, als diffuser Gasstrom 164 sich im Substrataufnahmeraum 30 in Richtung des Substrats 12 ausbreitet. Dieser diffuse Gasstrom 164 kann entweder dazu eingesetzt werden, im Zuge der thermischen Behandlung des Substrats 12 ein Prozessgas zuzuführen oder dazu eingesetzt werden, nach Beenden der Aufheizung des Substrats 12 eine rasche Abkühlung der substratseitigen Membran 60s durchzuführen und somit die Aufheizung des Substrats 12 möglichst abrupt zu beenden oder gegebenenfalls auch noch zusätzlich eine Kühlwirkung im Bereich der Oberseite 48 des Substrats 12 dadurch zu erhalten, dass die gekühlte Membran 60 als Wärmesenke wirkt.

Im Übrigen ist auch das achte Ausführungsbeispiel hinsichtlich der nicht im Einzelnen beschriebenen Merkmale in gleicher Weise ausgebildet wie die voranstehenden Ausführungsbeispiele, so dass diesbezüglich auf die Ausführungen zu den voranstehenden Ausführungsbeispielen Bezug genommen wird.

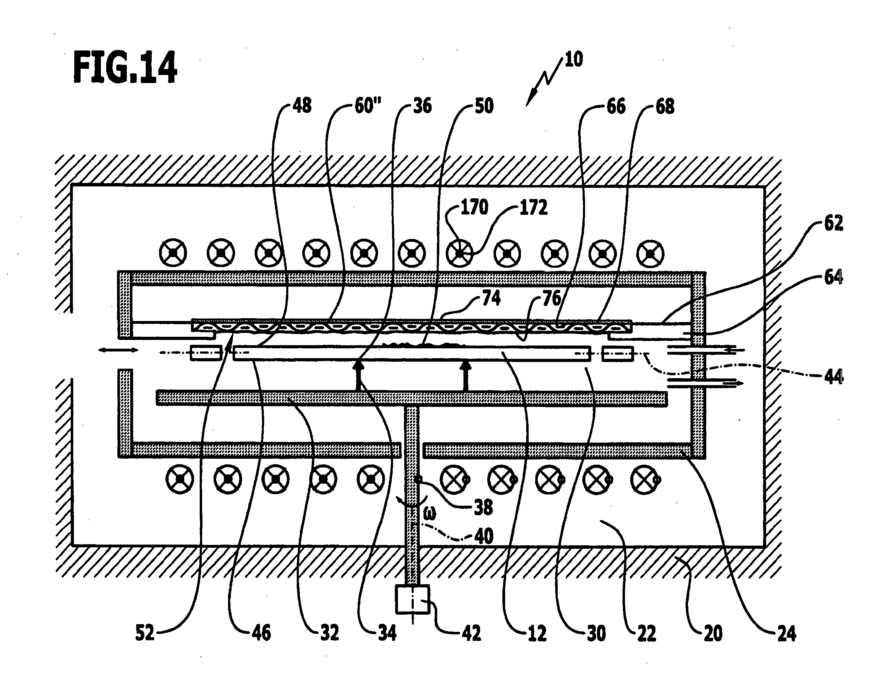

Bei einem neunten Ausführungsbeispiel einer erfindungsgemäßen Anlage, dargestellt in Fig. 14 ist die Membran 60 entsprechend dem vierten Ausführungsbeispiel gemäß Fig. 8 ausgebildet, wobei zusätzlich noch die Beschichtung 74 auf der dem Substrat 12 abgewandten Seite der Membran 60 eine elektrisch leitfähige Beschichtung ist. Beispielsweise kann die Beschichtung 74 durch eine Schicht aus Siliziumcarbid gebildet sein.

Die Aufheizung der Membran 60" erfolgt bei diesem Ausführungsbeispiel induktiv, so dass anstelle der Lampen 70 zwischen dem Außengehäuse 20 und dem Innengehäuse 24 eine entsprechend dem Zeitverlauf der thermischen Behandlung gesteuerte Induktionsspule 170 vorgesehen ist, deren Spulenwindungen 172 ein Magnetfeld erzeugen, das seinerseits zu Wirbelströmen in der Beschichtung 74 der Membran 60" führt und somit ein Aufheizen der Membran 60" bewirkt.

Damit dient die Membran 60" bei diesem neunten Ausführungsbeispiel der erfindungsgemäßen Anlage unmittelbar zur Erzeugung der erfindungsgemäß vorgesehenen Wärmestrahlung, so dass bei diesem Ausführungsbeispiel die Aufheizgeschwindigkeit und Abkühlgeschwindigkeit gegenüber den Ausführungsbeispielen mit den Lampen 70 noch verbessert werden kann, da die thermische Masse weiter reduziert ist und lediglich durch die Masse der Membran 60" gebildet ist.

Im Übrigen sind bei diesem Ausführungsbeispiel diejenigen Teile, die mit denen der voranstehenden Ausführungsbeispielen identisch sind, mit denselben Bezugszeichen versehen, so dass hinsichtlich der Beschreibung derselben auf die Ausführungen zu den voranstehenden Ausführungsbeispielen Bezug genommen werden kann.

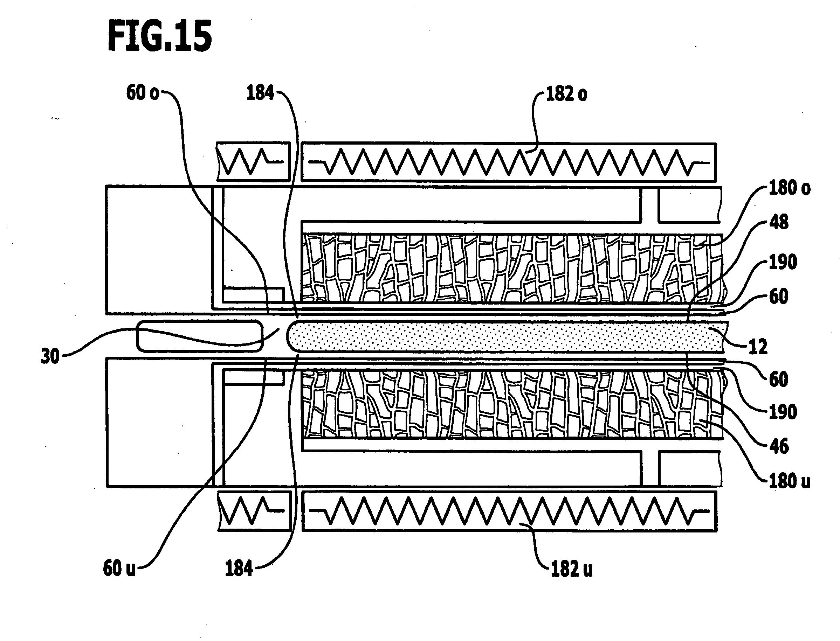

Bei einem zehnten Ausführungsbeispiel der erfindungsgemäßen Anlage, dargestellt in Fig. 15 erfolgt die Aufheizung der als Wärmetransferelement 52 dienenden Membran 60 weder durch entsprechend einem Zeitverlauf der thermischen Behandlung gesteuerte Lampen 70 noch durch eine Induktionsspule 170, sondern mittels eines die eine Heizeinrichtung darstellenden und konstant auf einer definierten Temperatur gehaltenen Aufheizblocks 180, der im Gegensatz zu den Lampen 70 und der Induktionsspule 170 nicht entsprechend dem Temperaturverlauf bei der thermischen Behandlung des Substrats 12 hinsichtlich seiner Temperatur gesteuert wird, sondern stets die konstante Temperatur beibehält und durch Heizelemente 182 geregelt auf einer konstanten Temperatur gehalten wird.

Ferner erfolgt bei diesem Ausführungsbeispiel die Aufheizung der Membran 60 primär nicht durch thermische Strahlung des Aufheizblocks 180, sondern durch Wärmeleitung über ein Gas, beispielsweise Prozessgas, welches in einem Zwischenraum 190 zwischen dem Aufheizblock 180 und der Membran 60 vorliegt und somit den Aufheizblock 180 mit der Membran 60 thermisch koppelt.

Das Gas tritt ferner noch durch die Membran 60 hindurch, welche in gleicher Weise wie beim ersten und zweiten Ausführungsbeispiel ausgebildet und somit gasdurchlässig ist, so dass das Gas auch durch die Membran 60 hindurchtritt und in den Substrataufnahmeraum 30 eintritt, wobei durch das Gas auch eine Wärmekopplung zwischen der Membran 60 und der Oberseite 48 des Substrats 12 auftritt, so dass primär durch das Gas die notwendige thermische Kopplung zwischen dem Aufheizblock 180 und schließlich dem Substrat 12 über die Membran 60 als Wärmetransferelement 52 erfolgt.

Das Substrat 12 wird in dem Substrataufnahmeraum 30 dadurch geführt, dass sowohl im geringen Abstand von der Oberseite 48 des Substrats 12 als auch in geringem Abstand von der Unterseite 46 des Substrats 12 die gemäß dem ersten oder zweiten Ausführungsbeispiel ausgebildete Membran 60 verläuft, welche von dem Gas, welches jeweils dem Zwischenraum 190 zugeführt wird, durchsetzt ist, so dass sich jeweils zwischen der Oberseite 48 des Substrats 12 und der oberen Membran 60o sowie der Unterseite 46 des Substrats 12 und der unteren Membran 60u ein Gaspolster 184 ausbildet, welches das Substrat 12 stabil zwischen der oberen Membran 60o und der unteren Membran 60u führt.

Dabei beträgt beispielsweise der Abstand zwischen der Oberseite 48 des Substrats 12 und der oberen Membran 60o sowie der Abstand zwischen der Unterseite 46 des Substrats 12 und der unteren Membran 60u weniger als 300 µm noch besser weniger als 200 µm und liegt beispielsweise in der Größenordnung von ungefähr 150 µm.

Bei diesen geringen Abständen zwischen den Membranen 60o und 60u erfolgt die thermische Kopplung zwischen den Membranen 60o und 60u sowie der Oberseite 48 und der Unterseite 46 des Substrats 12 über Wärmeleitung des Gases.

Um ferner auch eine optimale Wärmeleitung zwischen den Aufheizflächen 180o und 180u und der jeweiligen Membran 60o und 60u zu erhalten, ist auch der Abstand zwischen dem oberen Aufheizblock 180o und der oberen Membran 60o sowie dem Aufheizblock 180u und der unteren Membran 60u in der Größenordnung von weniger als 300 µm, noch besser weniger als 200 µm, so dass auch hier eine Wärmeleitung über das Gas in dem Zwischenraum 190 erfolgt.

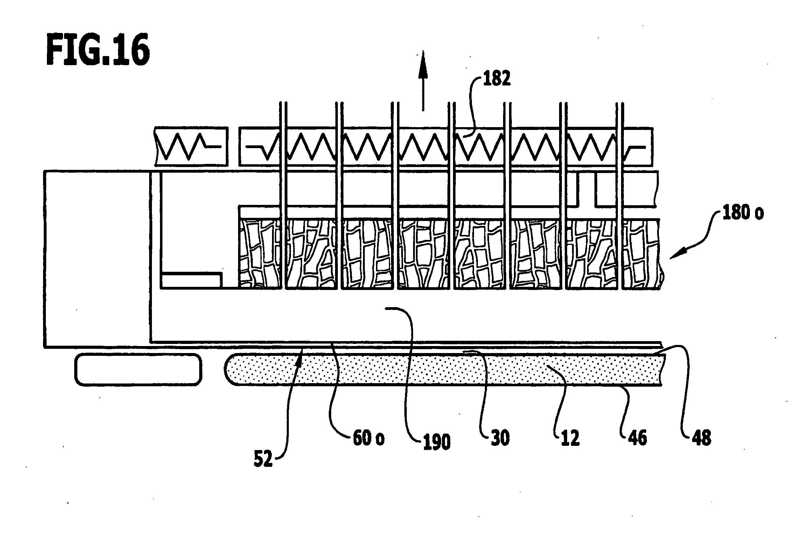

Soll nun die Aufheizung der jeweiligen Membran 60, beispielsweise der Membran 60o gestoppt werden, so wird, wie in Fig. 16 schematisch im Zusammenhang mit dem oberen Aufheizblock 180o und der oberen Membran 60o dargestellt, der Aufheizblock 180o von der Membran 600 unter Vergrößerung des Zwischenraums 190 schnell wegbewegt, so dass die Wärmeleitung über das Gas im Zwischenraum 190 vernachlässigbar ist.

Gleichzeitig erfolgt in dem Zwischenraum 190 die Zufuhr von kaltem Gas, so dass die Membran 60o rasch durch das kalte Gas abgekühlt wird, wobei diese Abkühlung sich aufgrund der Wärmeleitung über das Gas zwischen der jeweiligen Membran 60o und der Oberseite 48 des Substrats 12 auch auf das Substrat auswirkt, da zwischen der oberen Membran 60o und der Oberseite 48 des Substrats 12 nach wie vor die thermische Kopplung über das zwischen diesen vorhandene Gas relevant ist und somit im Wesentlichen gleichzeitig mit der raschen Abkühlung der Membran 60o eine rasche Abkühlung des Substrats 12 über die Oberseite 48 desselben erfolgt.

In gleicher Weise wirkt sich die Abkühlung zwischen der Unterseite 46 des Substrats und der unteren Membran 60u aus, wenn auch dort der untere Aufheizblock 180u wegbewegt und in den Zwischenraum 190 kaltes Gas eingeführt wird.

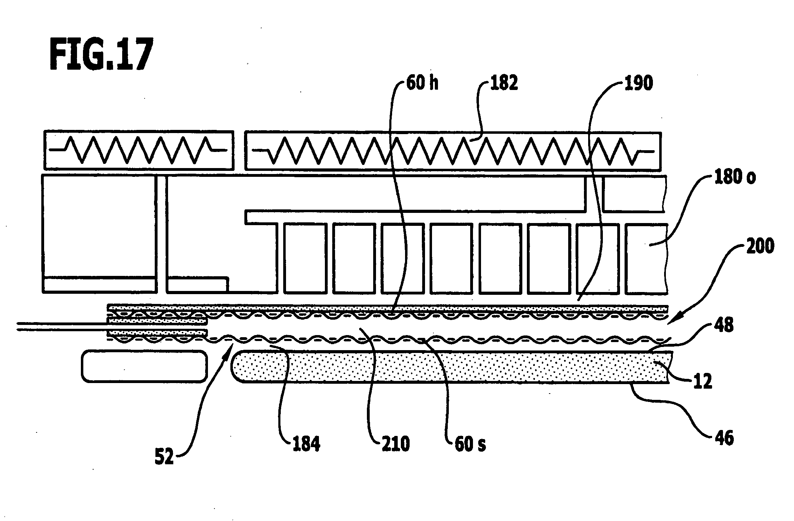

Bei einem elften Ausführungsbeispiel, dargestellt in Fig. 17, ist anstelle der jeweiligen, primäre Wärmequellen bildenden Membranen 60o und 60u ein Membranelement 200 vorgesehen, welches jeweils eine dem Substrat 12 zugewandte Membran 60s und eine dem Aufheizblock 180 zugewandte Membran 60h aufweist, die im Abstand voneinander angeordnet sind, so dass sich zwischen diesen ein Zwischenraum 210 bildet, welchem Gas zuführbar ist, das dann, in gleicher Weise wie beim zehnten Ausführungsbeispiel die Membran 60s durchsetzt und zur Ausbildung des Gaspolsters 184 beiträgt, welches das Substrat 12 führt.

Im Gegensatz dazu ist die Membran 60h als gasdichte Membran ausgeführt, so dass das in den Zwischenraum 210 eintretende Gas ausschließlich in Richtung des Substrats zur Ausbildung des Gaspolsters 184 strömt, jedoch nicht in Richtung des Aufheizblocks 180.

In gleicher Weise wie beim zehnten Ausführungsbeispiel wird der Zwischenraum 190 zwischen dem Aufheizblock 180 und der Membran 60h des Membranelements 200 minimiert, um eine Wärmeleitung zwischen dem Aufheizblock 180 und der Membran 60h des Membranelements 200 über das Gas zu erhalten, so dass der Zwischenraum 190 zwischen dem Aufheizblock 180 und der Membran 60h dieselben Dimensionen wie beim zehnten Ausführungsbeispiel aufweist. Hierzu ist allerdings lediglich dem Zwischenraum 190 ein die Wärmekopplung bewirkendes Gas zuzuführen.

Die Wärmekopplung zwischen den Membranen 60h und 60s des Membranelements 200 erfolgt ferner ebenfalls über das im Zwischenraum 210 vorhandene Gas, wobei ebenfalls der Abstand der Membranen 60s und 60h so gering ist, dass eine derartige Wärmekopplung über das Gas effizient erfolgt, also ebenfalls in einem Bereich von weniger als 300 µm, noch besser weniger als 200 µm liegt.

Durch das Membranelement 200 besteht nun die Möglichkeit, zum Beenden der Aufheizung ebenfalls den Aufheizblock 180 von dem Membranelement 200 wegzubewegen und gleichzeitig dem Zwischenraum 210 im Membranelement 200 kaltes Gas, beispielsweise sogar flüssigen Stickstoff, zuzuführen, welcher eine rasche Abkühlung zumindest der dem Substrat 12 zugewandten Membran 60s ermöglicht und somit gleichzeitig eine rasche Abkühlung der Oberseite 48 des Substrats 12, da die Oberseite 48 des Substrats 12 nach wie vor mit der Membran 60s über das Gaspolster 184 thermisch gekoppelt ist.

Aufgrund der Ausbildung des Membranelements 200 besteht somit die Möglichkeit, die Aufheizung des Substrats 12 durch die jeweiligen Aufheizblöcke 180 rasch zu beenden.

Das Membranelement 200 kann bei dem elften Ausführungsbeispiel entweder mechanisch so abgestützt sein, dass dieses unabhängig von der Bewegung der Aufheizblöcke 180 in seiner Position verbleibt.

Es besteht aber auch die Möglichkeit, wie in Fig. 17 dargestellt, dass das Membranelement gegenüber dem Aufheizblock 180 durch das in dem Zwischenraum 190 vorgesehene Gaspolster gegenüber dem Aufheizblock 180 abgestützt ist und seinerseits wiederum das Substrat 12 dadurch abstützt, dass sich das Gaspolster 184 zwischen der Membran 60s und der jeweiligen Seite des Substrats 12 ausbildet. In diesem Fall ist somit das Membranelement 200 einerseits gegenüber dem jeweiligen Aufheizblock 180 durch ein Gaspolster abgestützt und andererseits stützt es seinerseits wiederum durch ein Gaspolster das Substrat 12, so dass das Membranelement 200 nicht mechanisch relativ zu einem Gehäuse fixiert sein muss.

Im Übrigen ist das elfte Ausführungsbeispiel insoweit, als dieselben Teile wie mit einem der voranstehenden Ausführungsbeispiele Verwendung finden, mit denselben Bezugszeichen versehen, so dass auch hinsichtlich der Beschreibung und Funktion dieser Teile vollinhaltlich auf die Ausführungen zu den voranstehenden Ausführungsbeispiele Bezug genommen werden kann.

## Patentansprüche

1. Flächenhaft ausgebildetes aufheizbares Wärmetransferelement (52) für eine Anlage zur thermischen Behandlung eines Substrats (12), insbesondere Halbleitersubstraten, wobei die Anlage einen Substrataufnahmeraum (30) und auf mindestens einer Seite des Substrataufnahmeraums (30) das Wärmetransferelement aufweist, mit welchem das Substrat (12) im Substrataufnahmeraum (30) berührungslos durch Wärmebehandlung mit Temperaturänderungen thermisch behandelbar ist,
**dadurch gekennzeichnet, dass** das flächenhaft ausgebildete Wärmetransferelement (52) eine Membran (60) umfasst, dass die Membran (60) durch mindestens eine Matte (80) aus hochtemperaturbeständigen und thermoschockresistenten Fasern (84, 86) gebildet ist und dass die Fasern (84, 86) im Wesentlichen parallel zu einer Fläche (62) verlaufen, in welcher sich die Matte (80) erstreckt.

2. Wärmetransferelement nach Anspruch 1, **dadurch gekennzeichnet, dass** die hochtemperaturbeständigen Fasern (84, 86) einer Temperatur von mehr als 500°C Stand halten.

3. Wärmetransferelement nach einem der voranstehenden Ansprüche,
**dadurch gekennzeichnet, dass** die Matte (80) eine Dicke von maximal 0,5 mm aufweist.

4. Wärmetransferelement nach einem der voranstehenden Ansprüche, **dadurch gekennzeichnet, dass** die Matte (80) eine Dicke von mindestens 0,07 mm aufweist.

5. Wärmetransferelement nach einem der voranstehenden Ansprüche, **dadurch gekennzeichnet, dass** die Membran (60) eine Beschichtung (74, 76) trägt.

6. Wärmetransferelement nach einem der voranstehenden Ansprüche, **dadurch gekennzeichnet, dass** die Beschichtung (74, 76) eine durch Plasmaspritzen hergestellte Beschichtung ist.

7. Wärmetransferelement nach einem der Ansprüche 1 bis 5, **dadurch gekennzeichnet, dass** die Beschichtung (74, 76) eine durch PVD oder CVD oder CVI hergestellte Beschichtung ist.

8. Wärmetransferelement nach einem der Ansprüche 5 bis 7, **dadurch gekennzeichnet, dass** die Beschichtung (74, 76) eine Dicke von mindestens 10 nm (100 Å) aufweist.

9. Wärmetransferelement nach einem der voranstehenden Ansprüche, **dadurch gekennzeichnet, dass** die Membran (60) Durchlassöffnungen (128) aufweist.

10. Wärmetransferelement nach Anspruch 9, **dadurch gekennzeichnet, dass** ein Strömungsquerschnitt der Durchlassöffnungen in einem Zentralbereich (154) der Membran gegenüber einem Außenbereich (156) der Membran unterschiedlich ist.

11. Wärmetransferelement nach einem der voranstehenden Ansprüche, **dadurch gekennzeichnet, dass** das Membranelement (120, 200) einen Membranträger (100) aufweist, an welchem die Membran (60) gehalten ist.

12. Wärmetransferelement nach Anspruch 11, **dadurch gekennzeichnet, dass** die Membran (60) an dem Membranträger (100) gespannt gehalten ist.

13. Anlage zur thermischen Behandlung von Substraten (12), insbesondere Halbleitersubstraten, umfassend einen Substrataufnahmeraum (30) und eine auf mindestens einer Seite des Substrataufnahmeraums (30) angeordnetes, flächenhaft ausgebildetes aufheizbares Wärmtransferelement (52), mit welchem das Substrat (12) im Substrataufnahmeraum (30) durch Wärmebehandlung mit Temperaturänderungen thermisch behandelbar ist, **dadurch gekennzeichnet, dass** das Wärmetransferelement (52) nach einem der Ansprüche 1 bis 12 ausgebildet ist.

14. Anlage nach Anspruch 13, **dadurch gekennzeichnet, dass** das Wärmetransferelement (52) durch eine Heizeinrichtung (70, 170, 210) mechanisch berührungslos aufheizbar ist.

15. Anlage nach einem der Ansprüche 13 oder 14, **dadurch gekennzeichnet, dass** das Wärmetransferelement (52) zum Abkühlen des Substrats (12) mit einem Kühlgas kühlbar ist.

## Claims

1. Heatable heat transfer element (52) of an areal design for a system for the thermal treatment of a substrate (12), in particular semiconductor substrates, wherein the system has a substrate receiving space (30) and the heat transfer element on at least one side of the substrate receiving space (30), the substrate (12) being thermally treatable by means of said heat transfer element in the substrate receiving space (30) without contact as a result of heat treatment with changes in temperature,
**characterized in that** the heat transfer element (52) of an areal design comprises a membrane (60), that the membrane (60) is formed by at least one mat (80) consisting of fibres (84, 86) resistant to thermal shock and resistant to high temperatures and that the fibres (84, 86) extend essentially parallel to a surface (62), the mat (80) extending in said surface.

2. Heat transfer element as defined in claim 1, **characterized in that** the fibres (84, 86) resistant to high temperatures withstand a temperature of more than 500°C.

3. Heat transfer element as defined in either one of the preceding claims, **characterized in that** the mat (80) has a thickness of at the most 0.5 mm.

4. Heat transfer element as defined in any one of the preceding claims, **characterized in that** the mat (80) has a thickness of at least 0.07 mm.

5. Heat transfer element as defined in any one of the preceding claims, **characterized in that** the membrane (60) bears a coating (74, 76).

6. Heat transfer element as defined in any one of the preceding claims, **characterized in that** the coating (74, 76) is a coating produced by way of plasma spraying.

7. Heat transfer element as defined in any one of claims 1 to 5, **characterized in that** the coating (74, 76) is a coating produced by way of PVD or CVD or CVI.

8. Heat transfer element as defined in any one of claims 5 to 7, **characterized in that** the coating (74, 76) has a thickness of at least 10 nm (100 Å).

9. Heat transfer element as defined in any one of the preceding claims, **characterized in that** the membrane (60) has openings (128).

10. Heat transfer element as defined in claim 9, **characterized in that** a flow cross section of the openings is different in a central area (154) of the membrane in comparison with an outer area (156).

11. Heat transfer element as defined in any one of the preceding claims, **characterized in that** the membrane element (120, 200) has a membrane support (100), the membrane (60) being held on said support.

12. Heat transfer element as defined in claim 11, **characterized in that** the membrane (60) is held on the membrane support (100) in a tensioned manner.

13. System for the thermal treatment of substrates (12), in particular semiconductor substrates, comprising a substrate receiving space (30) and a heatable heat transfer element (52) of an areal design and arranged on at least one side of the substrate receiving space (30), the substrate (12) being thermally treatable with said heat transfer element in the substrate receiving space (30) as a result of heat treatment with changes in temperature, **characterized in that** the heat transfer element (52) is designed in accordance with any one of claims 1 to 12.

14. System as defined in claim 13, **characterized in that** the heat transfer element (52) is heatable in a mechanically non-contact manner by means of a heating device (70, 170, 210).

15. System as defined in either one of claims 13 or 14, **characterized in that** the heat transfer element (52) is coolable with a cooling gas for the purpose of cooling the substrate (12).

## Revendications

1. Elément de transfert thermique (52) pouvant être chauffé réalisé de manière plate destiné à une installation servant au traitement thermique d'un substrat (12), en particulier de substrats à semi-conducteurs, dans lequel l'installation présente un espace de réception de substrat (30) et, sur au moins un côté de l'espace de réception de substrat (30), l'élément de transfert thermique, à l'aide duquel le substrat (12) peut être traité thermiquement, dans l'espace de réception de substrat (30), sans contact par un traitement thermique à l'aide de variations de température,
**caractérisé en ce que** l'élément de transfert thermique (52) réalisé de manière plate comprend une membrane (60),
**en ce que** la membrane (60) est formée par au moins une natte (80) constituée de fibres (84, 86) résistantes aux températures élevées et résistantes aux chocs thermiques, et **en ce que** les fibres (84, 86) s'étendent essentiellement de manière parallèle par rapport à une surface (62), dans laquelle s'étend la natte (80).

2. Elément de transfert thermique selon la revendication 1, **caractérisé en ce que** les fibres (84, 86) résistantes aux températures élevées résistent à une température supérieure à 500 °C.

3. Elément de transfert thermique selon l'une quelconque des revendications précédentes, **caractérisé en ce que** la natte (80) présente une épaisseur de maximum 0,5 mm.

4. Elément de transfert thermique selon l'une quelconque des revendications précédentes, **caractérisé en ce que** la natte (80) présente une épaisseur d'au moins 0,07 mm.

5. Elément de transfert thermique selon l'une quelconque des revendications précédentes, **caractérisé en ce que** la membrane (60) comporte un revêtement (74, 76).

6. Elément de transfert thermique selon l'une quelconque des revendications précédentes, **caractérisé en ce que** le revêtement (74, 76) est un revêtement fabriqué par projection au plasma.

7. Elément de transfert thermique selon l'une quelconque des revendications 1 à 5, **caractérisé en ce que** le revêtement (74, 76) est un revêtement fabriqué par dépôt physique en phase vapeur ou par dépôt chimique en phase vapeur ou par infiltration chimique en phase vapeur.

8. Elément de transfert thermique selon l'une quelconque des revendications 5 à 7, **caractérisé en ce que** le revêtement (74, 76) présente une épaisseur d'au moins 10 nm (100 Å).

9. Elément de transfert thermique selon l'une quelconque des revendications précédentes, **caractérisé en ce que** la membrane (60) présente des ouvertures de passage (128).

10. Elément de transfert thermique selon la revendication 9, **caractérisé en ce qu'**une section d'écoulement des ouvertures de passage est différente dans une zone centrale (154) de la membrane par rapport à une zone extérieure (156) de la membrane.

11. Elément de transfert thermique selon l'une quelconque des revendications précédentes, **caractérisé en ce que** l'élément de membrane (120, 200) présente un support de membrane (100), au niveau duquel la membrane (60) est maintenue.

12. Elément de transfert thermique selon la revendication 11, **caractérisé en ce que** la membrane (60) est maintenue de manière tendue au niveau du support de membrane (100).

13. Installation servant au traitement thermique de substrats (12), en particulier de substrats à semi-conducteurs, comprenant un espace de réception de substrat (30) et un élément de transfert thermique (52) pouvant être chauffé, réalisé de manière plate, disposé sur au moins un côté de l'espace de réception de substrat (30), à l'aide duquel le substrat (12) peut être traité thermiquement, dans l'espace de réception de substrat (30), par un traitement thermique à l'aide de variations de température, **caractérisée en ce que** l'élément de transfert thermique (52) est réalisé selon l'une quelconque des revendications 1 à 12.

14. Installation selon la revendication 13, **caractérisée en ce que** l'élément de transfert thermique (52) peut être chauffé sans contact mécaniquement par un système de chauffage (70, 170, 210).

15. Installation selon l'une quelconque des revendications 13 ou 14, **caractérisée en ce que** l'élément de transfert thermique (52) peut être refroidi à l'aide d'un gaz de refroidissement aux fins du refroidissement du substrat (12).
